# EUROPÄISCHE PATENTSCHRIFT

(11) **EP 2 815 426 B1**
(45) Veröffentlichungstag und Bekanntmachung des Hinweises auf die Patenterteilung: **07.10.2020**
(21) Anmeldenummer: 13707567.7
(22) Anmeldetag: 08.02.2013
(51) Int. Cl.: H01L 21/673, H01L 21/67

(54) **PROZESSBOX, ANORDNUNGEN UND VERFAHREN ZUM PROZESSIEREN BESCHICHTETER SUBSTRATE**
PROCESS BOX, PROCESS HOLDER, ASSEMBLIES AND METHOD FOR PROCESSING COATED SUBSTRATES
BOÎTIER DE PROCESSUS, SUPPORT DE PROCESSUS, AGENCEMENTS ET PROCÉDÉ DE TRAITEMENT D'UN SUBSTRAT REVÊTU

(30) Priorität: 16.02.2012 EP 12155848
(43) Veröffentlichungstag der Anmeldung: 24.12.2014
(73) Patentinhaber: (CNBM) Bengbu Design & Research Institute for Glass Industry Co., Ltd., Bengbu (CN)
(72) Erfinder: FÜRFANGER, Martin, 85643 Steinhöring (DE); PHAN, Dang Cuong, 52062 Aachen (DE); JOST, Stefan, 81543 München (DE)
(74) Vertreter: Gebauer, Dieter Edmund
(86) Internationale Anmeldenummer: PCT/EP2013/052520
(87) Internationale Veröffentlichungsnummer: WO 2013/120779

(56) Entgegenhaltungen:
- EP-A1- 2 360 720
- EP-A1- 2 360 721
- WO-A2-2004/032593
- DE-A1-102008 022 784

## Beschreibung

Die Erfindung betrifft eine Prozessbox, Anordnungen und Verfahren zum Prozessieren einseitig beschichteter Substrate. Sie bezieht sich insbesondere auf die Wärmebehandlung von Substraten, die mit Vorläuferschichten zur Herstellung von Absorbern für Dünnschichtsolarzellen beschichtet sind.

Photovoltaische Schichtensysteme zur direkten Umwandlung von Sonnenlicht in elektrische Energie sind hinlänglich bekannt. Diese werden meist als "Solarzellen" bezeichnet, wobei sich der Begriff "Dünnschichtsolarzellen" auf Schichtensysteme mit geringen Dicken von nur wenigen Mikrometern bezieht, welche Substrate für eine ausreichende mechanische Festigkeit benötigen. Bekannte Substrate umfassen anorganisches Glas, Kunststoffe (Polymere) oder Metalle, insbesondere Metalllegierungen, und können in Abhängigkeit von der jeweiligen Schichtdicke und den spezifischen Materialeigenschaften als starre Platten oder biegsame Folien ausgestaltet sein.

Hinsichtlich der technologischen Handhabbarkeit und des Wirkungsgrads haben sich Dünnschichtsolarzellen mit einer Halbleiterschicht aus amorphem, mikromorphem oder polykristallinem Silizium, Cadmium-Tellurid (CdTe), Gallium-Arsenid (GaAs), Chalkopyrit-Verbindungen, insbesondere Kupfer-Indium/Gallium-Dischwefel/Diselenid, abgekürzt durch die Formel Cu(In,Ga) (S,Se)₂, oder Kesterit-Verbindungen, insbesondere Kupfer-Zink/Zinn-Dischwefel/Diselenid, abgekürzt durch die Formel Cu₂(Zn,Sn)(S,Se)₄ als vorteilhaft erwiesen.

Da mit einzelnen Solarzellen nur Spannungspegel von weniger als 1 Volt erreichbar sind, werden in der Regel viele Solarzellen in einem Solarmodul seriell miteinander verschaltet. Auf diese Weise können für Anwendungen brauchbare Ausgangsspannungen erhalten werden. Hierbei bieten Dünnschichtsolarmodule den besonderen Vorteil, dass die Solarzellen schon während der Schichtenherstellung in integrierter Form verschaltbar sind. In der Patentliteratur wurden seriell verschaltete Dünnschichtsolarmodule bereits vielfach beschrieben. Lediglich beispielhaft sei diesbezüglich auf die Druckschriften DE 4324318 C1 und EP 2200097 A1 verwiesen.

Die spezifischen Eigenschaften des Absorbers haben wesentlichen Einfluss auf die Lichtausbeute in Dünnschichtsolarmodulen. Bis in jüngste Zeit sind Aufbau und Zusammensetzung des Absorbers Gegenstand intensiver Forschungstätigkeit. Von den verschiedenen Möglichkeiten die Halbleiterschicht herzustellen, haben sich in den letzten Jahren im Wesentlichen zwei Verfahren durchgesetzt. Dies ist die Ko-Verdampfung der Einzelelemente auf ein heißes Substrat sowie das sukzessive Aufbringen der Elemente in Einzelschichten (Vorläuferschichten) beispielsweise durch Magnetron-Kathodenzerstäubung auf ein kaltes Substrat, verbunden mit einer anschließenden schnellen Wärmebehandlung (RTP = Rapid Thermal Processing), bei der die eigentliche Kristallbildung und Phasenumwandlung der Vorläuferschichten zur Halbleiterschicht erfolgt. Diese Vorgehensweise ist beispielsweise in J. Palm et al., "CIS module pilot processing applying concurrent rapid selenization and sulfurization of large area thin film precursors", Thin Solid Films 431-432, S. 414-522 (2003) eingehend beschrieben.

In der industriellen Serienfertigung erfolgt die RTP-Wärmebehandlung der Vorläuferschichten in so genannten In-Line-Anlagen, in denen die beschichteten Substrate über eine Einschleusekammer eingefahren und in Heizkammern gemäß einem genau festgelegten Temperaturverlauf erwärmt werden. Die Erwärmung erfolgt typischer Weise durch elektrisch betriebene Heizstrahler. Anschließend werden die prozessierten Substrate in Kühlkammern und/oder in einer Kühlstrecke gekühlt, gefolgt von einer Ausschleusung aus der In-Line-Anlage mittels einer Ausschleusekammer. Ein solches Verfahren ist beispielsweise aus der EP 0662247 B1 bekannt.

Generell ist die RTP-Wärmebehandlung ein kostenintensiver Prozess bei der Herstellung von Dünnschichtsolarzellen, welcher eine genaue Kontrolle der Prozessatmosphäre erfordert. Zu diesem Zweck ist es bekannt, den Prozessraum um das Substrat durch eine Prozessbox zu begrenzen. Dies ermöglicht, den Partialdruck der leicht flüchtigen Chalkogenkomponenten wie Selen oder Schwefel während der Wärmebehandlung zumindest weitestgehend konstant zu halten. Außerdem wird die Exposition der Wärmebehandlungskammer mit korrosiven Gasen reduziert. Eine solche Prozessbox ist beispielsweise aus der DE 102008022784 A1 bekannt.

Ferner zeigt die europäische Patentanmeldung EP 2360720 A1 eine transportierbare Prozessbox zum Prozessieren von zwei einseitig beschichteten Substraten, in der die beiden Substrate entweder mit ihren unbeschichteten Seiten aufeinander liegen oder durch einen Abstandshalter voneinander getrennt sind. Die zu prozessierenden Beschichtungen sind voneinander abgewandt ("back-to-back"). Das untere Substrat ist durch einen Abstandshalter vom Boden der Prozessbox beabstandet, wobei der Abstandshalter so ausgebildet ist, dass die nach unten zeigende Beschichtung des unteren Substrats frei zugänglich für Prozessgase ist. Eine vollflächige Auflage des unteren Substrats ist nicht möglich. Das untere Substrat wird durch die Gewichtskraft des oberen Substrats belastet. Die Beschichtungen der Substrate werden in unsymmetrischen Prozessräumen prozessiert.

Die europäische Patentanmeldung EP 2360721 A1 zeigt eine hiervon verschiedene Anordnung der beiden beschichteten Substrate. Hier sind die zu prozessierenden Beschichtungen einander zugewandt ("face-to-face"). Für die beiden Beschichtungen wird durch die Substrate selbst ein gemeinsamer Prozessraum gebildet. Eine vollflächige Auflage der Substrate ist nicht möglich. Zudem haben die beiden Beschichtungen keinen individuellen Prozessraum.

Die deutsche Patentanmeldung DE 102008022784 A1 zeigt eine Prozessbox mit einem einzelnen Substrat. Es ist angegeben, dass mehrere Substrate neben- oder hintereinander in eine Prozesskammer eingeschleust werden können, wobei beispielsweise eine entsprechend vergrößerte Prozessbox vorgesehen ist.

Die Aufgabe der vorliegenden Erfindung liegt darin, im Stand der Technik bekannte Prozessboxen zum Wärmebehandeln beschichteter Substrate in vorteilhafter Weise weiterzubilden. Insbesondere soll eine kostengünstige und energiesparende Prozessbox bereitgestellt werden, bei der der Anlagendurchsatz erhöht wird, ohne dass sich die Investitions- und Betriebskosten wesentlich erhöhen. Zudem sollen beschichtete Substrate mit einer besonders hohen Qualität in der industriellen Serienfertigung herstellbar sein.

Diese und weitere Aufgaben werden nach dem Vorschlag der Erfindung durch eine transportierbare Prozessbox, Anordnungen und Verfahren zum Prozessieren einseitig beschichteter Substrate gemäß den nebengeordneten Patentansprüchen gelöst. Bevorzugte Ausführungsformen der Erfindung gehen aus den Merkmalen der Unteransprüche hervor.

Im Sinne der Erfindung bezieht sich der Ausdruck "Substrat" auf einen flächigen Körper, der über zwei einander entgegen gesetzte Oberflächen verfügt, wobei auf einer der beiden Oberflächen ein typischer Weise eine Mehrzahl Schichten enthaltender Schichtenaufbau ("Beschichtung") aufgebracht ist. Die andere Oberfläche des Substrats ist in der Regel unbeschichtet. Vorzugsweise handelt es sich um ein mit Precursor- bzw. Vorläuferschichten eines Absorbers (z.B. Chalkopyrit- oder Kesterit-Verbindung) beschichtetes Substrat zur Herstellung eines Dünnschichtsolarmoduls, welches einer RTP-Wärmebehandlung unterzogen werden muss.

Der Ausdruck "lose" bezieht sich auf den Umstand, dass ein Körper auf einen anderen Körper aufgelegt bzw. aufgesetzt ist, wobei keine feste Verbindung bzw. keine Befestigung zwischen den Körpern vorliegt. Die beiden Körper können somit zerstörungsfrei, ohne Lösen eines Verbindungs- bzw. Befestigungsmittels, voneinander entfernt werden.

Die erfindungsgemäße Prozessbox ist so ausgebildet, dass sie zur Beladung mit Substraten zusammengebaut und insbesondere zum Entnehmen der prozessierten Substrate (zerstörungsfrei) wieder zerlegt werden kann.

Sie umfasst einen Boden, beispielsweise eine Bodenplatte, welcher so ausgebildet ist, dass ein erstes Substrat vollflächig unterstützt aufgelegt werden kann mit dessen unbeschichteter Substratseite, wobei der Boden weiterhin so ausgebildet ist, dass die Beschichtungen der beiden Substrate, im Wesentlichen bzw. überwiegend die Beschichtung des ersten Substrats, durch die Strahlungsenergie einer an der Unterseite des Bodens zugeführten Strahlung wärmebehandelt werden können.

Der Ausdruck "vollflächig unterstützt" bezieht sich hier und im Weiteren auf den Umstand, dass ein Substrat mit seiner Unterfläche (unbeschichtete Seite) auf den Boden oder das weiter unten genannte Zwischenelement gelegt wird, wobei die untere Substratfläche vollständig, d.h. in jedem Flächenabschnitt, unterstützt wird. Eine etwaige Verbiegung des Substrats bei der Wärmebehandlung kann dadurch verhindert werden.

Die Prozessbox umfasst weiterhin einen Rahmen zur Verbindung des Bodens mit einem Deckel, sowie den Deckel. Der Deckel ist so ausgebildet, dass die Beschichtungen der Substrate, im Wesentlich bzw. überwiegend die Beschichtung des zweiten Substrats, durch die Strahlungsenergie von an der Oberseite des Deckels zugeführte Strahlung wärmebehandelt werden können. Der Deckel ist vorzugsweise lose auf den Rahmen aufgesetzt. Gleichermaßen ist der Rahmen vorzugsweise lose auf den Boden aufgesetzt. Denkbar ist jedoch auch, dass der Rahmen mit dem Boden fest verbunden ist. Durch das Aufsetzen des Deckels auf den Rahmen kann in einfacher Weise ein gasdichter oder (ohne weitere Abdichtung) quasi-gasdichter Prozessraum realisiert werden.

Weiterhin umfasst die Prozessbox ein zwischen Boden und Deckel angeordnetes Zwischenelement, welches so ausgebildet ist, dass ein zweites Substrat mit seiner unbeschichteten Substratfläche vollflächig unterstützt auflegbar ist. Das Zwischenelement kann insbesondere in Form eines plattenförmigen Elements, d.h. Zwischenplatte, ausgebildet sein.

Durch Boden, Deckel und Rahmen wird ein (reduzierter) Prozessraum zum Prozessieren der beiden Substrate gebildet. Als Prozessraum im Sinne der Erfindung wird ein offener, quasi-geschlossener bzw. quasi-gasdichter oder gasdichter Prozessraum verstanden. Ein offener Prozessraum erlaubt einen freien Gasaustausch zwischen Prozessraum und äußerer Umgebung der Prozessbox. Im Unterschied hierzu ist bei einem gasdichten Prozessraum ein solcher Gasaustausch zwischen Prozessraum und äußerer Umgebung vollständig unterbunden. Bei einem quasi-geschlossenen bzw. quasi-gasdichten Prozessraum ist die Prozessbox bis zu einer bestimmten maximalen Druckdifferenz zwischen Prozessraum und äußerer Umgebung gasdicht. Bei Überschreiten der maximalen Druckdifferenz kommt es zu einem Druckausgleich zwischen Prozessraum und äußerer Umgebung. Die maximale Druckdifferenz hängt von der spezifischen Auslegung der Prozessbox ab.

Die Prozessbox kann Gasanschlüsse aufweisen, um den Prozessraum während bestimmter Prozessschritte gezielt mit einer bestimmten Gasatmosphäre zu versehen. Die Gasatmosphäre kann beispielsweise reaktive Gase wie H₂S, H₂Se, S-Dampf, Se-Dampf oder H₂ sowie Inertgase wie N₂, He oder Ar enthalten. Es versteht sich, dass die Prozessbox auch bei einem gasdichten oder quasi-gasdichten Prozessraum über Gasanschlüsse verfügen kann, durch die Prozess- oder Inertgase mit externem Überdruck in den Prozessraum einleitbar sind.

In der erfindungsgemäßen Prozessbox können Boden, Zwischenelement, Deckel und Rahmen grundsätzlich aus jedem für die beabsichtigte Verwendung geeigneten Material gefertigt sein. Vorzugsweise enthalten oder bestehen Boden, Zwischenelement, Deckel und Rahmen aus Metall, Glas, Keramik, Glaskeramik, carbonfaserverstärkte Kohlenstoffwerkstoffe oder Graphit. Hierbei soll der Boden dazu ausgebildet sein, eine Wärmebehandlung durch auf der Unterseite des Bodens zugeführte Wärmeenergie zu ermöglichen. Entsprechendes gilt für den Deckel, der dazu ausgebildet ist, eine Wärmebehandlung durch auf der Oberseite des Deckels zugeführte Wärmeenergie zu ermöglichen. Boden und Deckel können zu diesem Zweck transparent, teiltransparent oder undurchsichtig sein für elektromagnetische Strahlung zum Zuführen von Wärmeenergie zum Prozessieren der Substrate. Boden und Deckel können insbesondere auch ein Material (z.B. Graphit) enthalten oder aus einem solchen bestehen, welches geeignet ist, die elektromagnetische Strahlung von Strahlungsquellen zum Zuführen von Wärmeenergie zum Prozessieren der Substrate zumindest teilweise, insbesondere vollständig, zu absorbieren, um selbst aufgeheizt zu werden. Der aufgeheizte Boden bzw. Deckel kann dann als sekundäre Wärmequelle zum Aufheizen vor allem des jeweils angrenzenden Substrats dienen, was insbesondere zu einer Homogenisierung der Wärmeverteilung führen kann.

Die erfindungsgemäße Prozessbox ermöglicht in vorteilhafter Weise eine gleichzeitige Prozessierung (Wärmebehandlung) von zwei einseitig beschichteten Substraten. Durch die vollflächige Unterstützung der beiden Substrate kann die Gefahr einer Substratverbiegung aufgrund Schwerkrafteinwirkung bei Wärmebehandlung, die gewöhnlich oberhalb des Glaserweichungspunktes erfolgt, vermieden werden. Im Unterschied hierzu müssen in herkömmlichen Prozessboxen (z.B. EP 2360720 A1 und EP 2360721 A1) zur Vermeidung bzw. Verminderung einer Substratverbiegung zusätzliche Stützelemente vorgesehen werden. Hinzu kommt, dass - abhängig von der jeweiligen Konfiguration - zumindest bei einem der beiden Substrate eine Berührung der zu prozessierenden Beschichtung durch das Stützelement nicht vermieden werden kann. In der erfindungsgemäßen Prozessbox können die Substrate prozessiert werden, ohne dass eine Berührung der Beschichtung des jeweiligen Substrats erforderlich ist. Eine Schädigung der Beschichtung und/oder Substrats kann somit vermieden werden. Zudem ist die automatisierte Handhabung der Substrate erleichtert, da die beiden Substrate jeweils mit ihren Beschichtung nach oben weisend auf dem Boden bzw. Zwischenelement abgelegt werden können und somit nicht gedreht werden müssen. In den herkömmlichen Prozessboxen muss bei einer "face-to-face"-Konfiguration oder "back-to-back"-Konfiguration eines der beiden Substrate gedreht werden, was mit erhöhten Fertigungskosten und der Gefahr der Erhöhung von Ausschuss einher geht.

Ein weiterer wesentlicher Vorteil ergibt sich durch die Tatsache, dass die Prozessbox außerhalb einer Prozesskammer (z.B. Wärmebehandlungskammer) in einfacher und kostengünstiger Weise automatisiert zusammengebaut und beladen werden kann. Entsprechendes gilt für die Demontage der Prozessbox und das Entnehmen der prozessierten Substrate. Insofern ist in der Serienfertigung die Zyklenzeit zur kontinuierlichen Prozessierung von Substraten deutlich reduzierbar.

Bei einem gasdichten oder quasi-gasdichten Prozessraum sind die in die Prozessbox geladenen Substrate auch außerhalb der Prozesskammern vor Umwelteinflüssen gut geschützt. In einer In-Line-Anlage kann die beladene Prozessbox zwischen verschiedenen Prozesskammern transportiert werden, ohne dass die einseitig beschichteten Substrate aus dem Prozessraum entfernt werden müssen.

Die Prozessbox kann wahlfrei mit einem oder zwei Substraten beladen werden, wobei eine Beladung mit zwei Substraten zur Erhöhung des Durchsatzes bevorzugt ist. Die Beladung der Prozessbox kann in besonders einfacher Weise durch Auflegen der Substrate auf Boden und Zwischenelement erfolgen, so dass in der industriellen Serienfertigung eine einfache und kostengünstige Automatisierung ermöglicht ist.

Bei einer vorteilhaften Ausgestaltung der erfindungsgemäßen Prozessbox ist das Zwischenelement auf eine vom Rahmen geformte Stufe lose aufgesetzt, was einen besonders einfachen und schnellen Zusammenbau sowie Beladung der Prozessbox mit einseitig beschichteten Substraten in der industriellen Serienfertigung ermöglicht. Zudem wird der Prozessraum der Prozessbox in besonders einfacher Weise allein (ausschließlich) durch das Zwischenelement in zwei Prozessteilräume, nämlich einen ersten Prozessteilraum zum Prozessieren des ersten Substrats und einen zweiten Prozessteilraum zum Prozessieren des zweiten Substrats, unterteilt. Die beiden Prozessteilräume können strömungstechnisch miteinander verbunden sein. Alternativ ist es aber auch möglich, dass die beiden Prozessteilräume gasdicht oder quasi-gasdicht voneinander getrennt sind. Durch diese Maßnahme kann für jedes Substrat ein eigener Prozessteilraum spezifisch angepasst werden. Somit können die beiden Beschichtungen der Substrate beispielsweise unterschiedlich prozessiert werden. Vorzugsweise sind die Prozessteilräume symmetrisch ausgebildet, gegeben durch eine gleiche Höhe bzw. (vertikale) Abmessung der Prozessteilräume, so dass die Substrate einheitlich prozessierbar sind. Dies unterstützt das Erreichen hoher Qualitäts- und Güteanforderungen.

Bei einer hierzu alternativen Ausgestaltung ist die Prozessbox auf einen auf dem Boden abgestützten, ersten Abstandshalter und/oder auf einen auf dem ersten Substrat abgestützten, zweiten Abstandshalter lose aufgesetzt, wobei das Zwischenelement so ausgebildet ist, dass es gemeinsam mit dem ersten Abstandshalter oder zweiten Abstandshalter den Prozessraum in einen ersten Prozessteilraum zum Prozessieren des ersten Substrats und einen zweiten Prozessteilraum zum Prozessieren des zweiten Substrats unterteilt. Die Abstandshalter sind jeweils vom Rahmen verschieden. Durch die Abstandshalter ist ein besonders einfacher und schneller Zusammenbau sowie Beladung der Prozessbox mit einseitig beschichteten Substraten in der industriellen Serienfertigung ermöglicht. Vorzugsweise stützt sich der zweite Abstandshalter in einer beschichtungsfreien oder zumindest nicht als Funktionsfläche vorgesehenen Randzone des ersten Substrats ab. Bei Dünnschichtsolarmodulen ist eine solche Randzone regelmäßig vorgesehen, so dass in vorteilhafter Weise ein Verlust an optisch aktiver Fläche vermieden werden kann.

Die Erfindung erstreckt sich auch auf ein Verfahren zum Prozessieren einseitig beschichteter Substrate in einer erfindungsgemäßen, transportierbaren Prozessbox, wie sie oben beschrieben wurde, mit den folgenden Schritten:
In einem ersten Schritt wird die Prozessbox montiert und mit einem oder mehreren Substraten beladen. Zu diesem Zweck wird ein Boden bereitgestellt, durch den ein erstes Substrat vollflächig unterstützt werden kann und welcher so ausgebildet ist, dass die Beschichtungen der Substrate, im Wesentlichen bzw. überwiegend eine Beschichtung eines darauf aufgebrachten ersten Substrats, durch an der Unterseite des Bodens zugeführte Strahlungsenergie wärmebehandelt werden können. Auf den Boden wird ein Rahmen zur Verbindung des Bodens mit einem Deckel lose aufgesetzt. Gegebenenfalls wird ein erstes Substrat (mit seiner unbeschichteten Seite nach unten) auf den Boden gelegt. Zudem wird ein Zwischenelement angeordnet, durch das ein zweites Substrat vollflächig unterstützt werden kann. Gegebenenfalls wird ein zweites Substrat (mit seiner unbeschichteten Seite nach unten) auf das Zwischenelement gelegt. Anschließend wird der Deckel auf den Rahmen zur Ausbildung der Prozessbox lose aufgesetzt, wobei der Deckel so ausgebildet ist, dass die Beschichtungen der Substrate, im Wesentlichen bzw. überwiegend eine Beschichtung des zweiten Substrats, durch an der Oberseite des Deckels zugeführte Strahlungsenergie wärmebehandelbar sind. Durch Boden, Deckel und Rahmen wird ein Prozessraum zum Prozessieren der beiden Substrate gebildet. Die Prozessbox kann mit einem oder zwei Substraten beladen werden.

In einem zweiten Schritt wird die Prozessbox in eine Wärmebehandlungskammer mit Heizstrahlern transportiert.

In einem dritten Schritt wird Wärme- bzw. Strahlungsenergie an der Unterseite des Bodens zum Wärmebehandeln der Beschichtungen der Substrate, im Wesentlichen bzw. überwiegend der Beschichtung des ersten Substrats, zugeführt und/oder Wärme- bzw. Strahlungsenergie an der Oberseite des Deckelelements zum Wärmebehandeln der Beschichtungen der Substrate, im Wesentlichen bzw. überwiegend der Beschichtung des zweiten Substrats, zugeführt.

Durch das erfindungsgemäße Verfahren kann eine Prozessbox in einfacher Weise außerhalb der Prozesskammer automatisiert zusammengebaut und beladen werden. Ein oder zwei einseitig beschichtete Substrate können besonders einfach und kostengünstig mit hoher Fertigungsqualität prozessiert (wärmebehandelt) werden.

Bei einer vorteilhaften Ausgestaltung des erfindungsgemäßen Verfahrens wird das Zwischenelement auf eine vom Rahmen geformte Stufe lose aufgesetzt, was einen besonders einfachen Zusammenbau und Beladung der Prozessbox ermöglicht. Alternativ wird das Zwischenelement auf einen auf dem Boden abgestützten, ersten Abstandshalter und/oder auf einen auf dem ersten Substrat abgestützten, zweiten Abstandshalter lose aufgesetzt, was gleichermaßen einen besonders einfachen Zusammenbau und Beladung der Prozessbox ermöglicht.

Gezeigt ist weiterhin ein transportierbarer Prozessträger zur Ausbildung einer Prozessbox zum Prozessieren einseitig beschichteter Substrate. Hier und im Weiteren bezeichnet der Begriff "Prozessträger" eine vormontierbare offene Baugruppe zur Ausbildung der Prozessbox. Der Prozessträger umfasst einen Boden, der so ausgebildet ist, dass ein erstes Substrat vollflächig unterstützt auflegbar ist und die Beschichtungen der Substrate, im Wesentlichen bzw. überwiegend die Beschichtung des ersten Substrats, durch an der Unterseite des Bodens zugeführte Strahlungsenergie wärmebehandelbar sind. Ferner umfasst der Prozessträger einen Rahmen zur Verbindung des Bodens mit einem Deckel, wobei der Rahmen so ausgebildet ist, dass der Deckel lose aufsetzbar ist. Der Rahmen kann auf den Boden lose aufgesetzt sein. Alternativ ist der Rahmen mit dem Boden fest verbunden. Weiterhin umfasst der Prozessträger ein Zwischenelement, das so ausgebildet ist, dass ein zweites Substrat vollflächig unterstützt auflegbar ist, wobei das Zwischenelement auf eine vom Rahmen geformte Stufe lose aufgesetzt ist.

Der Prozessträger kann außerhalb einer Prozesskammer zusammengebaut und mit Substraten beladen und zum Entnehmen der prozessierten Substrate (zerstörungsfrei) zerlegt werden. Durch einen in einer Prozesskammer zum Prozessieren der beschichteten Substrate stationär angeordneten Deckel kann der Prozessträger zur Prozessbox vervollständigt werden. Hierdurch können Kosten in der Serienfertigung eingespart werden, da der Deckel wiederverwendbar ist und für die Prozessboxen keine separaten Deckel vorzusehen sind.

Ferner erstreckt sich die Erfindung auf eine Anordnung zum Prozessieren einseitig beschichteter Substrate in einer Prozessbox, welche einen wie vorstehend beschrieben ausgebildeten Prozessträger umfasst. Des Weiteren umfasst die Anordnung einen in einer Prozesskammer stationär angeordneten Deckel zum losen Aufsetzen auf den Rahmen des Prozessträgers zur Formung der Prozessbox, welcher so ausgebildet ist, dass die Beschichtungen der Substrate, im Wesentlichen bzw. überwiegend die Beschichtung des zweiten Substrats, durch an der Oberseite des Deckels zugeführte Strahlungsenergie wärmebehandelbar sind, sowie einen Bewegungsmechanismus zum relativen Bewegen von Deckel und Prozessträger. Der Bewegungsmechanismus ist so ausgebildet, dass der Deckel relativ zum Prozessträger und/oder der Prozessträger relativ zum Deckel bewegbar ist, um den Deckel auf den Rahmen aufzusetzen. Durch Boden, Rahmen und Deckel wird ein Prozessraum zum Prozessieren der beiden Substrate gebildet.

Die Erfindung erstreckt sich weiterhin auf ein Verfahren zum Prozessieren einseitig beschichteter Substrate in einer Prozessbox in einer wie vorstehend beschrieben ausgebildeten Anordnung.

In einem ersten Schritt wird der wie oben beschrieben ausgebildete Prozessträger zusammengebaut und mit einem oder mehreren Substraten beladen. Zu diesem Zweck wird bei einer ersten Alternative ein Boden bereitgestellt, durch den ein erstes Substrat vollflächig unterstützt werden kann und welcher so ausgebildet ist, dass die Beschichtungen der Substrate, im Wesentlichen bzw. überwiegend eine Beschichtung eines darauf aufgebrachten ersten Substrats, durch an der Unterseite des Bodens zugeführte Strahlungsenergie wärmebehandelt werden kann. Auf den Boden wird ein Rahmen zur Verbindung des Bodens mit einem Deckel lose aufgesetzt. Bei einer zweiten Alternative wird ein Boden bereitgestellt, der mit dem Rahmen fest verbunden ist. Gegebenenfalls wird auf den Boden das erste Substrat (mit seiner unbeschichteten Seite nach unten) aufgelegt. Zudem wird ein Zwischenelement, durch das ein zweites Substrat vollflächig unterstützt werden kann, bei einer ersten Alternative auf eine vom Rahmen geformte Stufe oder bei einer zweiten Alternative auf einen auf dem Boden abgestützten, ersten Abstandshalter und/oder auf einen auf dem ersten Substrat abgestützten, zweiten Abstandshalter, lose aufgesetzt. Gegebenenfalls wird auf das Zwischenelement das zweite Substrat (mit seiner unbeschichteten Seite nach unten) gelegt.

In einem zweiten Schritt wird der beladene Prozessträger in eine Wärmebehandlungskammer mit Heizstrahlern transportiert.

In einem dritten Schritt wird ein in der Wärmebehandlungskammer stationär angeordneter Deckel auf den Rahmen zur Ausbildung der Prozessbox lose aufgesetzt, wobei der Deckel so ausgebildet ist, dass die Beschichtungen der Substrate, im Wesentlichen bzw. überwiegend, eine Beschichtung des zweiten Substrats, durch an der Oberseite des Deckels zugeführte Strahlungsenergie wärmebehandelbar ist. Durch Boden, Rahmen und Deckel wird ein Prozessraum zum Prozessieren der beiden Substrate gebildet.

In einem vierten Schritt wird Wärme- bzw. Strahlungsenergie an der Unterseite des Bodens zum Wärmebehandeln der Beschichtungen der Substrate, im Wesentlichen bzw. überwiegend der Beschichtung des ersten Substrats, zugeführt und/oder Wärme- bzw. Strahlungsenergie an der Oberseite des Deckels zum Wärmebehandeln der Beschichtungen der Substrate, im Wesentlichen bzw. überwiegend der Beschichtung des zweiten Substrats, zugeführt.

Durch das erfindungsgemäße Verfahren kann ein offener Prozessträger in einfacher Weise außerhalb der Prozesskammer automatisiert zusammengebaut und beladen werden. Ein oder zwei einseitig beschichtete Substrate können besonders einfach und kostengünstig mit hoher Fertigungsqualität prozessiert (wärmebehandelt) werden.

Gezeigt ist weiterhin ein transportierbarer offener Prozessträger zur Ausbildung einer Prozessbox zum Prozessieren einseitig beschichteter Substrate, mit einem Boden, welcher so ausgebildet ist, dass ein erstes Substrat vollflächig unterstützt auflegbar ist und Beschichtungen der Substrate durch an der Unterseite des Bodens zugeführte Strahlung wärmebehandelbar sind, einem Zwischenelement, welches so ausgebildet ist, dass ein zweites Substrat vollflächig unterstützt auflegbar ist, wobei das Zwischenelement auf einen auf dem Boden abgestützten, ersten Abstandshalter und/oder auf einen auf dem ersten Substrat abgestützten, zweiten Abstandshalter lose aufgesetzt ist.

Ein solcher Prozessträger kann zur Beladung mit Substraten außerhalb einer Prozesskammer zusammengebaut und zum Entnehmen der prozessierten Substrate (zerstörungsfrei) zerlegt werden. Durch den in einer Prozesskammer stationär angeordneten Deckel mit dem damit fest verbundenen Rahmen kann der Prozessträger zur Prozessbox vervollständigt werden. Hierdurch können Kosten in der Serienfertigung eingespart werden.

Ferner erstreckt sich die Erfindung auf eine Anordnung zum Prozessieren einseitig beschichteter Substrate in einer Prozessbox, welche einen wie unmittelbar vorstehend beschrieben ausgebildeten Prozessträger umfasst. Ferner umfasst die Anordnung einen in einer Prozesskammer stationär angeordneten Deckel mit einem daran befestigten Rahmen zum Aufsetzen auf das Boden zur Formung der Prozessbox, wobei der Deckel so ausgebildet ist, dass Beschichtungen der Substrate, im Wesentlichen bzw. überwiegend eine Beschichtung des zweiten Substrats, durch an der Oberseite des Deckels zugeführte Strahlungsenergie wärmebehandelbar ist. Des Weiteren umfasst die Anordnung einen Bewegungsmechanismus zum Bewegen von Deckel mit Rahmen und/oder Prozessträger, welcher so ausgebildet ist, dass der Rahmen auf den Boden aufsetzbar ist. Durch Boden, Deckel und Rahmen wird ein Prozessraum zum Prozessieren der beiden Substrate gebildet.

Die Erfindung erstreckt sich weiterhin auf ein Verfahren zum Prozessieren einseitig beschichteter Substrate in einer wie unmittelbar vorstehend beschrieben ausgebildeten Anordnung.

In einem ersten Schritt wird ein entsprechender Prozessträger zusammengebaut und mit einem oder mehreren Substraten beladen. Zu diesem Zweck wird ein Boden bereitgestellt, durch den das erste Substrat vollflächig unterstützt werden kann und welcher so ausgebildet ist, dass die Beschichtungen der Substrate, im Wesentlichen bzw. überwiegend eine Beschichtung eines darauf aufgebrachten ersten Substrats, durch an der Unterseite des Bodens zugeführte Strahlungsenergie wärmebehandelt werden können. Gegebenenfalls wird ein erstes Substrat (mit der unbeschichteten Seite nach unten) auf den Boden gelegt. Zudem wird ein Zwischenelement, durch das ein zweites Substrat vollflächig unterstützt werden kann, auf einen auf dem Boden abgestützten, ersten Abstandshalter und/oder auf einen auf dem ersten Substrat abgestützten, zweiten Abstandshalter lose aufgesetzt. Gegebenenfalls wird ein zweites Substrat (mit der unbeschichteten Seite nach unten) auf das Zwischenelement gelegt.

In einem zweiten Schritt wird der beladene Prozessträger in eine Wärmebehandlungskammer mit Heizstrahlern transportiert.

In einem dritten Schritt wird ein in der Wärmebehandlungskammer stationär angeordneter, mit einem Deckel fest verbundener Rahmen auf den Boden zur Ausbildung der Prozessbox lose aufgesetzt, wobei der Deckel so ausgebildet ist, dass die Beschichtungen der Substrate, im Wesentlichen bzw. überwiegend eine Beschichtung des zweiten Substrats, durch an der Oberseite des Deckels zugeführte Strahlungsenergie wärmebehandelbar sind. Durch Boden, Rahmen und Deckel wird ein (reduzierter) Prozessraum zum Prozessieren der beiden Substrate gebildet.

In einem vierten Schritt wird Wärmeenergie an der Unterseite des Bodens zum Wärmebehandeln der Beschichtungen der Substrate, im Wesentlichen bzw. überwiegend der Beschichtung des ersten Substrats zugeführt, und/oder es wird Wärmeenergie an der Oberseite des Deckels zum Wärmebehandeln der Beschichtungen der Substrate, im Wesentlichen bzw. überwiegend der Beschichtung des zweiten Substrats, zugeführt.

Durch das erfindungsgemäße Verfahren kann ein offener Prozessträger in einfacher Weise außerhalb der Prozesskammer automatisiert zusammengebaut und beladen werden. Zwei einseitig beschichtete Substrate können besonders einfach und kostengünstig mit hoher Fertigungsqualität prozessiert (wärmebehandelt) werden. Durch das Vorsehen eines stationären Deckels und stationären Rahmens können Fertigungskosten eingespart werden. Da Deckel und Rahmen fest miteinander verbunden sind, kann der Prozessträger in einfacher Weise zur Prozessbox vervollständigt werden.

### Kurze Beschreibung der Zeichnungen

Die Erfindung wird nun anhand von Ausführungsbeispielen näher erläutert, wobei Bezug auf die beigefügten Figuren genommen wird. Es zeigen in vereinfachter, nicht maßstäblicher Darstellung:
- Fig. 1: anhand einer Querschnittsdarstellung ein Ausführungsbeispiel der erfindungsgemäßen Prozessbox zum Prozessieren einseitig beschichteter Substrate;
- Fig. 2: eine Variante der Prozessbox von Fig. 1 mit einem Prozessträger und einem stationären Deckel;
- Fig. 3: eine weitere Variante der Prozessbox von Fig. 1.

In den Figuren ist eine in typischer Arbeitsposition horizontal orientierte Prozessbox 1 gezeigt, wobei es sich versteht, dass die Prozessbox 1 auch anders orientiert sein kann. Die in der folgenden Beschreibung gemachten Lage- und Richtungsangaben beziehen sich auf die Darstellung der Prozessbox 1 in den Figuren und dienen lediglich einer einfacheren Beschreibung der Erfindung, wobei die Erfindung hierdurch nicht eingeschränkt sein soll.

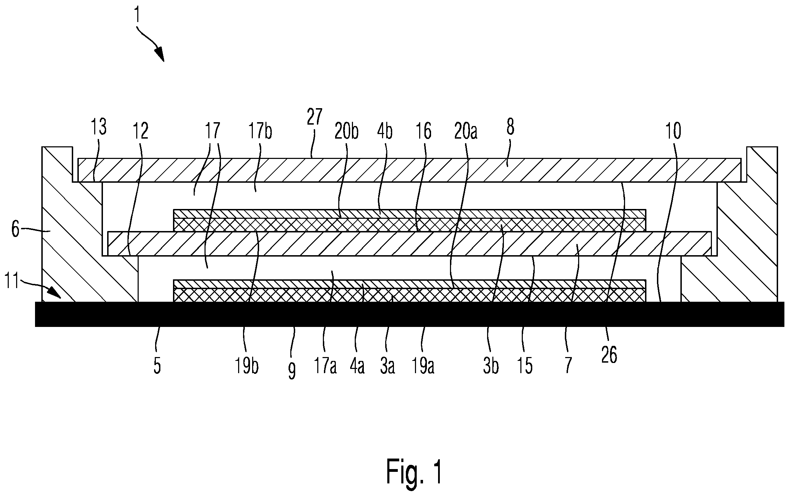

Sei zunächst Fig. 1 betrachtet, worin ein Ausführungsbeispiel der Prozessbox 1 anhand einer Vertikalschnittdarstellung veranschaulicht ist. Die Prozessbox 1 dient zum Prozessieren von einseitig beschichteten Substraten 3a, 3b, beispielsweise zur Herstellung von Dünnschichtsolarmodulen. Obgleich zwei Substrate 3a, 3b gezeigt sind, versteht es sich, dass die Prozessbox 1 gleichermaßen zum Prozessieren nur eines einzigen Substrats eingesetzt werden kann.

Demnach umfasst die Prozessbox 1 einen ebenen Boden 5, der hier beispielsweise als Platte bzw. quaderförmiger Körper mit einer unteren Bodenfläche 9 und einer oberen Bodenfläche 10 ausgebildet ist. In einem Randbereich 11 des Bodens 5 ist ein geschlossener Rahmen 6 auf die obere Bodenfläche 10 lose aufgesetzt. Denkbar wäre jedoch auch, dass der Rahmen 6 mit dem Boden 5 fest verbunden ist.

Wie in der Vertikalschnittdarstellung von Fig. 1 gut erkennbar, weist der Rahmen 6 zwei horizontale Stufen 12, 13 auf, die jeweils als Auflagefläche dienen. So ist auf eine untere Stufe 12 ein ebenes Zwischenelement 7 lose aufgesetzt, das hier beispielsweise als Platte bzw. quaderförmiger Körper mit einer unteren Zwischenfläche 15 und einer oberen Zwischenfläche 16 ausgebildet ist. Auf die obere Stufe 13 ist ein ebener Deckel 8 lose aufgesetzt, der hier beispielsweise als Platte bzw. quaderförmiger Körper mit einer unteren Deckelfläche 26 und einer oberen Deckelfläche 27 ausgebildet ist.

In der Prozessbox 1 sind Boden 5, Zwischenelement 7 und Deckel 8 stapelförmig über- bzw. untereinander angeordnet. Dabei wird durch Boden 5 und Deckel 8 gemeinsam mit dem Rahmen 6 ein gasdichter oder quasi-gasdichter Prozessraum 17 umgrenzt, wobei der Prozessraum 17 nur durch das Zwischenelement 7 in einen unteren Prozessteilraum 17a und einen oberen Prozessteilraum 17b unterteilt wird. Die beiden Prozessteilräume 17a, 17b sind symmetrisch ausgebildet und haben in etwa gleiche Höhe, gegeben durch die lichte Weite zwischen den einander benachbarten Platten. Im vorliegenden Ausführungsbeispiel sind die beiden Prozessteilräume 17a, 17b gasdicht oder quasi-gasdicht voneinander abgegrenzt, wobei es gleichermaßen denkbar wäre, dass die beiden Prozessteilräume 17a, 17b strömungstechnisch miteinander verbunden sind, so dass ein wechselseitiger Gasaustausch erfolgen kann.

Fig. 1 zeigt eine mit zwei einseitig beschichteten Substraten 3a, 3b beladene Prozessbox 1, wobei jedes Substrat 3a, 3b hier beispielsweise als quaderförmiger Körper mit einer unteren Substratfläche 19a, 19b und einer oberen Substratfläche 20a, 20b ausgebildet ist. Auf der oberen Substratfläche 20a, 20b ist jeweils ein Schichtenaufbau 4a, 4b aufgebracht. Bei der Herstellung von Dünnschichtsolarmodulen handelt es sich bei dem Schichtenaufbau 4a, 4b beispielsweise um die einer RTP-Wärmebehandlung zu unterziehenden Vorläufer- bzw. Precursorschichten zur Herstellung eines Absorbers. Hierbei liegt das untere Substrat 3a mit seiner unteren Substratfläche 19a dem Boden 5 auf und wird von der oberen Bodenfläche 10 vollflächig unterstützt. In entsprechender Weise liegt das obere Substrat 3b mit seiner unteren Substratfläche 19b dem Zwischenelement 7 auf und wird von der oberen Zwischenfläche 16 vollflächig unterstützt. Bei beiden Substraten 3a, 3b befindet sich der Schichtenaufbau 4a, 4b jeweils auf der dem Deckel 8 zugewandten Substratseite.

Somit befindet sich das untere Substrat 3a im unteren Prozessteilraum 17a und das obere Substrat 3b im oberen Prozessteilraum 17b. Da es für eine einheitliche Prozessatmosphäre, insbesondere während einer RTP-Wärmebehandlung des Schichtenaufbaus 4a, 4b, in wesentlicher Weise auf die Bemessung der lichten Weite des jeweiligen Prozessteilraums 17a, 17b ankommt, welche für die beiden Substrate 3a, 3b zumindest annähernd gleich ist, können die beiden Prozessteilräume 17a, 17b als symmetrisch im Hinblick auf die Prozessatmosphäre angesehen werden. Dies unterstützt die Einhaltung besonders hoher Güte- und Qualitätsanforderungen, denen beispielsweise Dünnschichtsolarmodule in aller Regel genügen müssen.

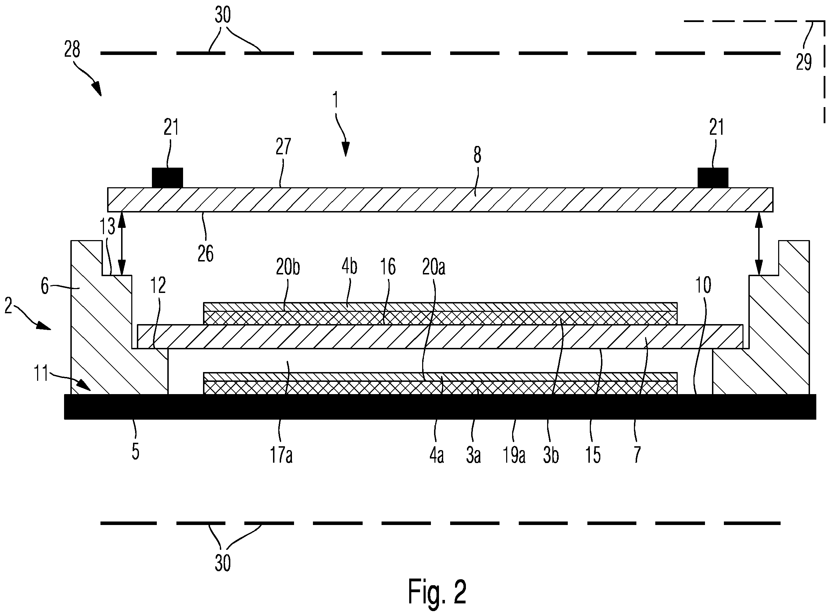

Die verschiedenen Bestandteile der Prozessbox 1 können aus einem gleichen Material oder voneinander verschiedenen Materialien bestehen. Typische Materialien sind Metall, Glas, Keramik, Glaskeramik carbonfaserverstärkte Kohlenstoffwerkstoffe oder Graphit. Wesentlich hierbei ist, dass der Boden 5 so ausgebildet ist, dass eine Wärmebehandlung des Schichtenaufbaus 4a des unteren Substrats 3a durch auf der Unterseite des Bodens 5 bzw. an der unteren Bodenfläche 9 in Form von Strahlung zugeführte Wärmeenergie ermöglicht ist. In entsprechender Weise ist der Deckel 8 so ausgebildet, dass eine Wärmebehandlung des Schichtenaufbaus 4b des oberen Substrats 3b durch auf der Oberseite des Deckels 8 bzw. an der oberen Deckelfläche 27 in Form von Strahlung zugeführte Wärmeenergie ermöglicht ist. Die Wärmeenergie kann in einer in Fig. 2 schematisch angedeuteten Wärmebehandlungskammer 29 durch oberhalb des Deckels 8 sowie unterhalb des Bodens 5 beispielsweise reihenförmig angeordnete Heizstrahler 30 zugeführt werden, auf deren Ausgestaltung hier nicht näher eingegangen werden muss.

Beispielsweise umfassen Boden 5 und/oder Deckel 8 zu diesem Zweck ein Material, das transparent oder zumindest teiltransparent für die eingestrahlte elektromagnetische Strahlung ist, beispielsweise Glaskeramik. Gleichermaßen ist es auch möglich, dass Boden 5 und/oder Deckel 8 ein Material umfassen, welches geeignet ist, die elektromagnetische Strahlung zumindest teilweise, insbesondere vollständig, zu absorbieren, um selbst aufgeheizt zu werden, beispielsweise Graphit. Im letztgenannten Fall dienen Boden 5 und/oder Deckel 8 als passiv geheizte, sekundäre Wärmequellen.

Die beiden Substrate 3a, 3b bestehen beispielsweise aus Glas mit einer Dicke im Bereich von 1 mm bis 4 mm, insbesondere 2 mm bis 3 mm. Wie bereits erwähnt, sind die beiden Substrate 3a, 3b jeweils auf ihrer oberen Substratfläche 20a, 20b mit einem Schichtenaufbau 4a, 4b versehen, welcher beispielsweise aus dünnen Vorläuferschichten eines Absorbers (z.B. Chalkopyrit- oder Kesterit-Verbindung) besteht, die einer RTP-Wärmebehandlung unterzogen werden müssen. Beispielsweise handelt es sich bei dem Schichtenaufbau 4a, 4b um eine Abfolge der Schichten Siliziumnitrid/Molybdän/Kupfer-Indium-Gallium/Selen. Beispielsweise hat die Siliziumnitrid-Schicht eine Dicke im Bereich von 50 nm bis 300 nm, die Molybdän-Schicht eine Dicke im Bereich von 200 nm bis 700 nm, die Kupfer-Indium-Gallium-Schicht eine Dicke im Bereich von 300 nm bis 1000 nm und die Selen-Schicht eine Dicke im Bereich von 500 nm bis 2000 nm.

Die Prozessbox 1 kann in einfacher Weise außerhalb einer Prozesskammer (z.B. Wärmebehandlungskammer) zum Prozessieren der Substrate 3a, 3b automatisiert zusammengebaut und mit den einseitig beschichteten Substraten 3a, 3b beladen werden. Beispielsweise wird zu diesem Zweck zunächst der Rahmen 6 lose auf die obere Bodenfläche 10 gelegt und anschließend das untere Substrat 3a mit der unteren Substratfläche 19a lose auf die obere Bodenfläche 10 gelegt. Denkbar ist jedoch auch, dass der Rahmen 6 mit der oberen Bodenfläche 10 fest verbunden ist. Das untere Substrat 3a befindet sich hierbei innerhalb des geschlossenen Rahmens 6. Dann wird das Zwischenelement 7 lose auf die untere Stufe 12 gelegt, wodurch sich der geschlossene oder quasigeschlossene, untere Prozessteilraum 17a ergibt. Anschließend wird das zweite Substrat 3b mit der unteren Substratfläche 19b lose auf die obere Zwischenfläche 16 gelegt. Schließlich wird der Deckel 8 lose auf die obere Stufe 13 gelegt, wodurch sich der geschlossene oder quasi-geschlossene, obere Prozessteilraum 17b ergibt.

Die Prozessbox 1 kann über Anschlussbuchsen (nicht gezeigt) verfügen, durch die dem Prozessraum 17 insgesamt oder den Prozessteilräumen 17a, 17b jeweils separat ein Prozess- oder Inertgas zugeführt werden kann.

Wie eingangs beschrieben, erfolgt in der industriellen Serienfertigung von Dünnschichtsolarmodulen eine Prozessierung der Substrate 3a, 3b in einer In-Line-Anlage, in der die beladene Prozessbox 1 verschiedenen Prozesskammern nacheinander zugeführt wird. Wie dem Fachmann an sich bekannt ist, kann der Transport der Prozessbox 1 beispielsweise auf Stummelrollen erfolgen, welche die Prozessbox 1 an der unteren Bodenfläche 9 abstützen. Die Transportgeschwindigkeit beträgt typischerweise bis zu 1 m/s.

Beispielsweise wird die mit Substraten 3a, 3b beladene Prozessbox 1 zunächst in eine Einschleusekammer eingefahren, von wo aus sie in eine Wärmebehandlungskammer zur RTP-Wärmebehandlung des Schichtenaufbaus 4a, 4b der beiden Substrate 3a, 3b transportiert wird. Bei der RTP-Wärmebehandlung werden die Substrate 3a, 3b beispielsweise mit einer Aufheizgeschwindigkeit von 1°C/s bis 50°C/s auf eine Temperatur von beispielsweise 350°C bis 800°C durch Heizstrahler aufgeheizt. Beispielsweise werden dabei Vorläuferschichten aus Kupfer, Indium, Gallium und Selen in einer schwefelhaltigen Atmosphäre in eine Cu(In,Ga) (S,Se)₂-Halbleiterschicht umgewandelt. Anschließend wird die beladene Prozessbox 1 in eine Kühlkammer zur Kühlung der Substrate 3a, 3b eingefahren. Die heißen Substrate 3a, 3b werden beispielsweise mit bis zu 50°C/s bis zu einer prozesstechnisch notwendigen Temperatur, beispielsweise 10°C bis 380°C, abgekühlt. Die Kühlung kann beispielsweise durch Kühlplatten erfolgen und durch einen zirkulierenden Gasstrom beschleunigt werden, beispielsweise ein Luft-, Argon- oder Stickstoffstrom. Alternativ ist eine Kühlung durch Konvektions- oder Zwangskühlung ohne Kühlplatten realisierbar. Anschließend wird die beladene Prozessbox 1 aus der Kühlkammer in eine Ausschleusekammer eingefahren, von wo aus die Substrate 3a, 3b einer weiteren Verarbeitung zugeführt werden können. Es versteht sich, dass der Aufbau einer solchen In-Line-Anlage von den speziellen Anforderungen zur Herstellung von Dünnschichtsolarmodulen abhängt, wobei insbesondere weitere Wärme- und/oder Kühlkammern sowie Kühlstrecken vorgesehen sein können. Gleichermaßen kann gegebenenfalls auf eine Einschleuse- und/oder Ausschleusekammer verzichtet werden.

Die Prozessbox 1 ermöglicht eine chargenweise Beschickung der In-Line-Anlage, wobei in verschiedenen Prozesskammern beladene Prozessboxen gleichzeitig prozessiert werden können. Insbesondere können Substrate 3a, 3b in einer Kühlkammer gekühlt werden, während weitere Substrate 3a, 3b in einer Wärmebehandlungskammer einer RTP-Wärmebehandlung unterzogen werden.

In Fig. 2 ist eine Variante der Prozessbox 1 von Fig. 1 dargestellt. Um unnötige Wiederholungen zu vermeiden, werden lediglich die Unterschiede zur Prozessbox von Fig. 1 dargestellt und ansonsten wird auf die Ausführungen zu Fig. 1 Bezug genommen. Demnach unterscheidet sich die Prozessbox 1 dahingehend, dass ein offener Prozessträger 2, bestehend aus Boden, 5, Rahmen 6 und Zwischenelement 7 außerhalb der In-Line-Anlage bzw. außerhalb einer Prozesskammer zusammengebaut und mit Substraten 3a, 3b beladen wird. Die Prozessbox 1 wird erst in einer jeweiligen Prozesskammer vervollständigt.

Wie in Fig. 2 gezeigt, ist zu diesem Zweck der Deckel 8 in einer Wärmebehandlungskammer 29 stationär (ortsfest) angeordnet. Der Deckel 8 kann durch einen nicht näher dargestellten Bewegungsmechanismus 21 in seiner vertikalen Position verstellt werden, um dem offenen Prozessträger 2 zugestellt zu werden, wobei der Deckel 8 auf die obere Stufe 13 lose aufgesetzt wird. Somit wird der Prozessraum 17 erst in der Wärmebehandlungskammer 29 ausgebildet. Diese Variante hat den Vorteil, dass immer derselbe Deckel 8 nacheinander für mehrere beladene Prozessträger 2 verwendbar ist, so dass nicht für jede Prozessbox 1 ein separater Deckel 8 vorgesehen werden muss. Hierdurch können Kosten in der Serienfertigung eingespart werden. Diese Variante hat zudem den Vorteil, dass ein selber Deckel 8 nicht ständig aufgeheizt und abgekühlt werden muss und somit Energiekosten eingespart werden können. Der offene Prozessträger 2 formt gemeinsam mit dem stationären Deckel 8 und dem Bewegungsmechanismus 21 eine Anordnung zum Prozessieren der Substrate 3a, 3b, welche in Fig. 2 insgesamt mit der Bezugszahl 28 bezeichnet ist.

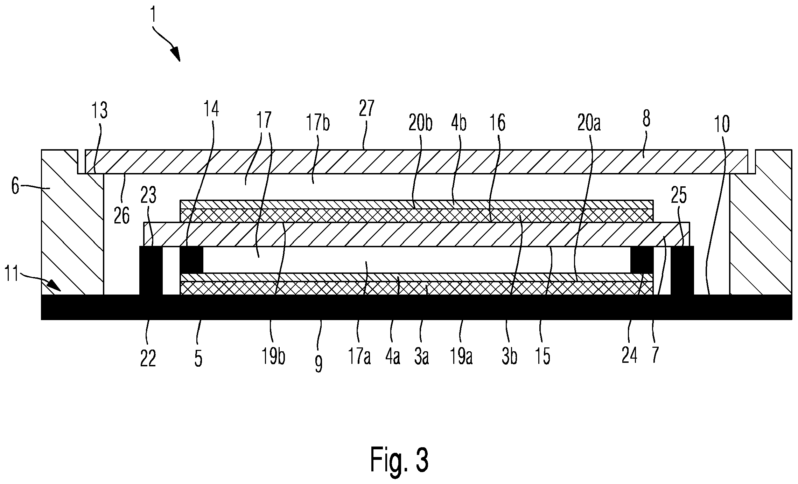

In Fig. 3 ist eine weitere Variante der Prozessbox 1 von Fig. 1 dargestellt, wobei wiederum lediglich die Unterschiede zur Prozessbox 1 von Fig. 1 erläutert werden und ansonsten auf die dortigen Ausführungen Bezug genommen wird.

Demnach umfasst der Rahmen 6 keine untere Stufe 12 zum Aufsetzen des Zwischenelements 7, sondern lediglich eine obere Stufe 13 zum Aufsetzen des Deckels 8. Anstelle der unteren Stufe 12 sind Abstandshalter 22, 24 vorgesehen, die jeweils in Form eines geschlossenen Rahmens ausgebildet sind. So dient die Oberseite eines ersten Abstandshalters 22, welcher auf die obere Bodenfläche 10 lose aufgesetzt ist, als erste Auflagefläche 23 für das Zwischenelement 7. Andererseits dient die Oberseite eines weiter innen liegenden, zweiten Abstandshalters 24, welcher im Unterschied zum ersten Abstandshalter 22 auf die Oberseite des unteren Substrats 3a lose aufgesetzt ist, als zweite Auflagefläche 25 für das Zwischenelement 7. Da beschichtete Substrate 3a, 3b zur Herstellung von Dünnschichtsolarmodulen in der Regel über eine beschichtungsfreie oder zumindest nicht als optisch aktive Fläche vorgesehene Randzone 14 verfügen, ist es vorteilhaft, wenn sich der zweite Abstandshalter 24 im Bereich dieser beschichtungsfreien Randzone 38 am unteren Substrat 3a abstützt, so dass durch den zweiten Abstandshalter 24 keine Verminderung der Leistung bewirkt wird.

Der Zusammenbau und die Beladung der Prozessbox 1 erfolgt beispielsweise in der Weise, dass zunächst der Rahmen 6 auf die obere Bodenfläche 10 lose aufgesetzt wird. Anschließend wird innerhalb des Rahmens 6 das erste Substrat 3a mit seiner unteren Substratfläche 19a auf die obere Bodenfläche 10 lose aufgesetzt. Dann werden die beiden rahmenartigen Abstandshalter 22, 24 in Stellung gebracht, wobei der erste Abstandshalter 22 auf die obere Bodenfläche 10 und der zweite Abstandshalter 24 auf das untere Substrat 3a lose aufgesetzt werden. Anschließend wird das Zwischenelement 7 auf die beiden Auflageflächen 23, 25 lose gelegt, wodurch der untere Prozessteilraum 17a vervollständigt wird. Auf die obere Zwischenfläche 16 wird dann das zweite Substrat 3b mit seiner unteren Substratfläche 19b lose aufgesetzt. Schließlich wird der Deckel 8 lose auf die obere Stufe 13 gesetzt, wodurch der obere Prozessteilraum 17b vervollständigt wird. Die Prozessbox 1 kann somit in einfacher, zuverlässiger und kostengünstiger Weise automatisiert zusammengebaut und beladen werden.

Gleichermaßen wäre es möglich, dass in Entsprechung zu Fig. 2, lediglich ein offener Prozessträger 2, bestehend aus Boden 5, Rahmen 6 und Zwischenelement 7 oder bestehend aus Boden 5 und Zwischenelement 7, in der voran stehend beschriebenen Weise außerhalb der In-Line-Anlage bzw. einer Prozesskammer montiert und beladen wird. In diesem Fall wird ein in einer Prozesskammer stationär angeordnete Deckel 8 zur Fertigstellung der Prozessbox 1 dem Prozessträger 2 zugestellt. Alternativ wäre es auch möglich, dass in einer Prozesskammer der stationär angeordnete Deckel 8 sowie der Rahmen 6 dem Prozessträger 2 zugestellt werden. Vorteilhaft ist zu diesem Zweck der Deckel 8 mit dem Rahmen 6 fest verbunden. Somit ist nicht für jede Prozessbox 1 ein separater Deckel 8 sowie gegebenenfalls ein separater Rahmen 6 vorzusehen.

Die erfindungsgemäße Prozessbox 1 ermöglicht eine Prozessierung einseitig beschichteter Substrate 3a, 3b, wobei die Prozessbox 1 oder ein offener Prozessträger 2 außerhalb einer Prozesskammer automatisiert montiert und mit den Substraten 3a, 3b beladen werden kann. Durch die vollflächige Unterstützung der beiden Substrate 3a, 3b kann in besonders vorteilhafter Weise eine durch die Schwerkraft hervorgerufene Substratverbiegung vermieden werden. Insbesondere bei einer RTP-Wärmebehandlung, die typischerweise oberhalb des Glaserweichungspunktes erfolgt, kann auf diese Weise eine Verbiegung gläserner Substrate 3a, 3b zuverlässig und sicher vermieden werden. Zudem muss der Schichtenaufbau 4a, 4b der beiden Substrate 3a, 3b weder vor noch während oder nach der Prozessierung berührt werden, so dass eine mechanische Schädigung vermieden werden kann. Insbesondere muss die Stellung der beiden Substrate 3a, 3b für die Prozessierung nicht verändert werden, beispielsweise durch Drehen der Substrate 3a, 3b, so dass die automatisierte Prozessierung stark vereinfacht ist. Der Prozessraum 17 der Prozessbox 1 kann in besonders vorteilhafter Weise zumindest annähernd symmetrisch in die beiden Prozessteilräume 17a, 17b unterteilt werden, so dass die beiden Substrate 3a, 3b mit einer gleichen Prozessatmosphäre prozessiert werden können. Zudem kann die Wärmezufuhr an der Ober- und Unterseite der Prozessbox 1 so gesteuert werden, dass innerhalb der beiden Substrate 3a, 3b eine möglichst homogene Wärmeverteilung vorliegt. Dies ist im Hinblick auf eine kontrollierte Umsetzung der Precursor-Materialien zum Absorber bei einer RTP-Wärmebehandlung erwünscht. Die Prozessbox 1 unterstützt somit die Herstellung beschichteter Substrate für Dünnschichtsolarmodule mit hohen Güte- bzw. Qualitätsanforderungen.

Weitere Merkmale der Erfindung ergeben sich aus nachfolgender Beschreibung:
Eine transportierbare Prozessbox zum Prozessieren einseitig beschichteter Substrate, umfassend: einen Boden zum vorzugsweise vollflächig unterstützten Auflegen eines ersten Substrats, wobei der Boden so ausgebildet ist, dass Beschichtungen der Substrate durch an der Unterseite des Bodens zugeführte Strahlung wärmebehandelbar sind, einen Rahmen zum Verbinden des Bodens mit einem Deckel, ein Zwischenelement zum vorzugsweise vollflächig unterstützten Auflegen eines zweiten Substrats, einen Deckel, der auf den Rahmen aufgesetzt und so ausgebildet ist, dass Beschichtungen der Substrate durch an der Oberseite des Deckels zugeführte Strahlung wärmebehandelbar sind.

Bei einer Ausgestaltung der Prozessbox wird der Prozessraum (allein) durch das Zwischenelement in einen ersten Prozessteilraum zum Prozessieren des ersten Substrats und einen zweiten Prozessteilraum zum Prozessieren des zweiten Substrats unterteilt. Bei einer weiteren Ausgestaltung der Prozessbox ist das Zwischenelement auf den Rahmen aufgesetzt. Bei einer weiteren Ausgestaltung der Prozessbox ist das Zwischenelement auf einen auf dem Boden abgestützten, ersten Abstandshalter und/oder auf einen auf dem ersten Substrat abgestützten, zweiten Abstandshalter aufgesetzt. Bei einer weiteren Ausgestaltung der Prozessbox stützt sich der zweite Abstandshalter in einer beschichtungsfreien Randzone des ersten Substrats ab. Bei einer weiteren Ausgestaltung der Prozessbox ist der Rahmen auf den Boden aufgesetzt. Die Ausgestaltungen der Prozessbox sind beliebig miteinander kombinierbar.

Ein transportierbarer Prozessträger für eine Prozessbox zum Prozessieren einseitig beschichteter Substrate, umfassend einen Boden zum vorzugsweise vollflächig unterstützten Auflegen eines ersten Substrats, wobei der Boden so ausgebildet ist, dass Beschichtungen der Substrate durch an der Unterseite des Bodens zugeführte Strahlung wärmebehandelbar sind, einen Rahmen zum Verbinden des Bodens mit einem Deckel, wobei der Rahmen so ausgebildet ist, dass der Deckel aufsetzbar ist, ein Zwischenelement zum vorzugsweise vollflächig unterstützten Auflegen eines zweiten Substrats, wobei das Zwischenelement auf den Rahmen aufgesetzt ist.

Eine Anordnung zum Prozessieren einseitig beschichteter Substrate in einer Prozessbox, umfassend: einen transportierbaren Prozessträger wie vorstehend beschrieben, einen in einer Prozesskammer stationär angeordneten Deckel zum Aufsetzen auf den Rahmen des Prozessträgers zur Formung der Prozessbox, wobei der Deckel so ausgebildet ist, dass Beschichtungen der Substrate durch an der Oberseite des Deckels zugeführte Strahlung wärmebehandelbar sind, ein Bewegungsmechanismus zum Bewegen von Deckel und/oder Prozessträger, wobei der Bewegungsmechanismus so ausgebildet ist, dass der Deckel auf den Rahmen aufsetzbar ist.

Ein transportierbarer Prozessträger für eine Prozessbox zum Prozessieren einseitig beschichteter Substrate, umfassend: einen Boden zum vorzugsweise vollflächig unterstützten Auflegen eines ersten Substrats, wobei der Boden so ausgebildet ist, dass Beschichtungen der Substrate durch an der Unterseite des Bodens zugeführte Strahlung wärmebehandelbar sind, ein Zwischenelement zum vorzugsweise vollflächig unterstützten Auflegen eines zweiten Substrats, wobei das Zwischenelement auf einen auf dem Boden abgestützten, ersten Abstandshalter und/oder auf einen auf dem ersten Substrat abgestützten, zweiten Abstandshalter aufgesetzt ist.

Eine Anordnung zum Prozessieren einseitig beschichteter Substrate in einer Prozessbox, umfassend: einen transportierbaren Prozessträger wie unmittelbar vorstehend beschrieben, einen in einer Prozesskammer stationär angeordneten Deckel mit einem daran befestigten Rahmen zum Verbinden von Boden und Deckel zur Formung der Prozessbox, wobei der Deckel so ausgebildet ist, dass Beschichtungen der Substrate durch an der Oberseite des Deckels zugeführte Strahlungsenergie wärmebehandelbar sind, ein Bewegungsmechanismus zum Bewegen von Deckel mit Rahmen und/oder Prozessträger, welcher so ausgebildet ist, dass der Rahmen auf den Boden aufsetzbar ist.

Ein Verfahren zum Prozessieren einseitig beschichteter Substrate in einer transportierbaren Prozessbox, mit den folgenden Schritten: a) Montieren und Beladen der Prozessbox durch Bereitstellen eines Bodens, durch den ein erstes Substrat vorzugsweise vollflächig unterstützt werden kann und welcher so ausgebildet ist, dass Beschichtungen von Substraten durch an der Unterseite des Bodens zugeführte Strahlung wärmebehandelbar sind, Aufsetzen eines Rahmens auf den Boden zur Verbindung des Bodens mit einem Deckel, gegebenenfalls Auflegen des ersten Substrats auf den Boden, Anordnen eines Zwischenelements, durch das ein zweites Substrat vorzugsweise vollflächig unterstützt werden kann, gegebenenfalls Auflegen des zweiten Substrats auf das Zwischenelement, Aufsetzen des Deckels auf den Rahmen zur Ausbildung der Prozessbox, wobei der Deckel so ausgebildet ist, dass Beschichtungen der Substrate durch an der Oberseite des Deckels zugeführte Strahlung wärmebehandelbar sind, b) Transportieren der Prozessbox in eine Wärmebehandlungskammer mit Heizstrahlern, c) Zuführen von Strahlung an der Unterseite des Bodens und/oder Zuführen von Strahlung an der Oberseite des Deckels zum Wärmebehandeln der Beschichtungen der Substrate. Bei einer Ausgestaltung des Verfahrens wird das Zwischenelement auf den Rahmen aufgesetzt. Bei einer weiteren Ausgestaltung des Verfahrens wird das Zwischenelement auf einen auf dem Boden abgestützten, ersten Abstandshalter und/oder auf einen auf dem ersten Substrat abgestützten, zweiten Abstandshalter aufgesetzt. Die Ausgestaltungen des Verfahrens sind beliebig miteinander kombinierbar.

Ein Verfahren zum Prozessieren einseitig beschichteter Substrate in einer Prozessbox, mit den folgenden Schritten: a) Montieren und Beladen eines transportierbaren Prozessträgers, durch Bereitstellen eines Bodens, durch den ein erstes Substrat vorzugsweise vollflächig unterstützt werden kann und welcher so ausgebildet ist, dass Beschichtungen der Substrate durch an der Unterseite des Bodens zugeführte Strahlung wärmebehandelbar sind, Aufsetzen eines Rahmens auf den Boden zur Verbindung des Bodens mit einem Deckel, gegebenenfalls Auflegen des ersten Substrats auf den Boden, Aufsetzen eines Zwischenelements, durch das ein zweites Substrat vorzugsweise vollflächig unterstützt werden kann, auf den Rahmen, gegebenenfalls Auflegen des zweiten Substrats auf das Zwischenelement, b) Transportieren des Prozessträgers in eine Wärmebehandlungskammer mit Heizstrahlern, c) Aufsetzen eines in der Wärmebehandlungskammer stationär angeordneten Deckels auf den Rahmen zur Ausbildung der Prozessbox, wobei der Deckel so ausgebildet ist, dass Beschichtungen der Substrate durch an der Oberseite des Deckels zugeführte Strahlung wärmebehandelbar sind, d) Zuführen von Strahlung an der Unterseite des Bodens und/oder Zuführen von Strahlung an der Oberseite des Deckels zum Wärmebehandeln der Beschichtungen der Substrate.

Ein Verfahren zum Prozessieren einseitig beschichteter Substrate in einer Prozessbox, mit den folgenden Schritten: a) Montieren und Beladen eines transportierbaren Prozessträgers, durch Bereitstellen eines Bodens, durch den ein erstes Substrat vorzugsweise vollflächig unterstützt werden kann und welcher so ausgebildet ist, dass Beschichtungen der Substrate durch an der Unterseite des Bodens zugeführte Strahlung wärmebehandelbar sind, gegebenenfalls Auflegen des ersten Substrats auf den Boden, Aufsetzen eines Zwischenelements, durch das ein zweites Substrat vorzugsweise vollflächig unterstützt werden kann, auf einen auf dem Boden abgestützten ersten Abstandshalter und/oder auf einen auf dem ersten Substrat abgestützten, zweiten Abstandshalter, gegebenenfalls Auflegen des zweiten Substrats auf das Zwischenelement, b) Transportieren des beladenen Prozessträgers in eine Wärmebehandlungskammer mit Heizstrahlern, c) Aufsetzen eines in der Wärmebehandlungskammer stationär angeordneten, mit einem Deckel fest verbundenen Rahmens auf den Boden zur Ausbildung der Prozessbox, wobei der Deckel so ausgebildet ist, dass Beschichtungen der Substrate durch an der Oberseite des Deckels zugeführte Strahlung wärmebehandelbar sind, d) Zuführen von Strahlung an der Unterseite des Bodens und/oder Zuführen von Strahlung an der Oberseite des Deckels zum Wärmebehandeln der Beschichtungen der Substrate.

### Bezugszeichenliste

- 1: Prozessbox
- 2: Prozessträger
- 3a, 3b: Substrat
- 4a, 4b: Schichtenaufbau
- 5: Boden
- 6: Rahmen
- 7: Zwischenelement
- 8: Deckel
- 9: untere Bodenfläche
- 10: obere Bodenfläche
- 11: Randbereich
- 12: untere Stufe
- 13: obere Stufe
- 14: Randzone
- 15: untere Zwischenfläche
- 16: obere Zwischenfläche
- 17: Prozessraum
- 17a, 17b: Prozessteilraum
- 19a, 19b: untere Substratfläche
- 20a, 20b: obere Substratfläche
- 21: Bewegungsmechanismus
- 22: erster Abstandshalter
- 23: erste Auflagefläche
- 24: zweiter Abstandshalter
- 25: zweite Auflagefläche
- 26: untere Deckelfläche
- 27: obere Deckelfläche
- 28: Anordnung
- 29: Wärmebehandlungskammer
- 30: Heizstrahler

## Patentansprüche

1. Transportierbare Prozessbox (1) zum Prozessieren einseitig beschichteter Substrate (3a, 3b), umfassend:
einen Boden (5), welcher so ausgebildet ist, dass ein erstes Substrat (3a) mit seiner unbeschichteten Substratseite vollflächig unterstützt auflegbar ist und Beschichtungen (4a, 4b) der Substrate (3a, 3b) durch an der Unterseite (9) des Bodens (5) zugeführte Strahlung wärmebehandelbar sind,
einen Rahmen (6) zum Verbinden des Bodens (5) mit einem Deckel (8),
ein Zwischenelement (7), welches so ausgebildet ist, dass ein zweites Substrat (3b) mit seiner unbeschichteten Substratseite vollflächig unterstützt auflegbar ist,
einen Deckel (8), der auf den Rahmen (6) aufgesetzt und so ausgebildet ist, dass Beschichtungen (4a, 4b) der Substrate (3a, 3b) durch an der Oberseite (27) des Deckels (8) zugeführte Strahlung wärmebehandelbar sind, wobei durch Boden (5), Deckel (8) und Rahmen (6) ein Prozessraum (17) zum Prozessieren der Substrate (3a, 3b) gebildet wird.

2. Prozessbox (1) nach Anspruch 1, bei welcher das Zwischenelement (7) auf eine vom Rahmen (6) geformte Stufe (12) lose aufgesetzt ist, wobei das Zwischenelement (7) den Prozessraum (17) in einen ersten Prozessteilraum (17a) zum Prozessieren des ersten Substrats (3a) und einen zweiten Prozessteilraum (17b) zum Prozessieren des zweiten Substrats (3b) unterteilt.

3. Prozessbox (1) nach Anspruch 1, bei welcher das Zwischenelement (7) auf einen auf dem Boden (5) abgestützten, ersten Abstandshalter (22) und/oder auf einen auf dem ersten Substrat (3a) abgestützten, zweiten Abstandshalter (24) lose aufgesetzt ist, wobei das Zwischenelement (7) so ausgebildet ist, dass es gemeinsam mit dem ersten Abstandshalter (22) oder zweiten Abstandshalter (24) den Prozessraum (17) in einen ersten Prozessteilraum (17a) zum Prozessieren des ersten Substrats (3a) und einen zweiten Prozessteilraum (17b) zum Prozessieren des zweiten Substrats (3b) unterteilt.

4. Prozessbox (1) nach Anspruch 3, bei welcher sich der zweite Abstandshalter (24) in einer beschichtungsfreien Randzone (14) des ersten Substrats (3a) abstützt.

5. Prozessbox (1) nach einem der Ansprüche 1 bis 4, bei welcher der Rahmen (6) auf den Boden (5) lose aufgesetzt ist.

6. Verfahren zum Prozessieren einseitig beschichteter Substrate (3a, 3b) in einer transportierbaren Prozessbox (1) nach einem der Ansprüche 1 bis 5, mit den folgenden Schritten:
a) Montieren und Beladen der Prozessbox (1) durch
- Bereitstellen eines Bodens (5), durch den ein erstes Substrat (3a) mit seiner unbeschichteten Substratseite vollflächig unterstützt werden kann und welcher so ausgebildet ist, dass Beschichtungen (4a, 4b) von Substraten (3a, 3b) durch an der Unterseite (9) des Bodens (5) zugeführte Strahlung wärmebehandelbar sind,
- loses Aufsetzen eines Rahmens (6) auf den Boden (5) zur Verbindung des Bodens (5) mit einem Deckel (8),
- gegebenenfalls Auflegen des ersten Substrats (3a) auf den Boden (5),
- Anordnen eines Zwischenelements (7), durch das ein zweites Substrat (3b) mit seiner unbeschichteten Substratseite vollflächig unterstützt werden kann,
- gegebenenfalls Auflegen des zweiten Substrats (3a) auf das Zwischenelement (7),
- Aufsetzen des Deckels (8) auf den Rahmen (6) zur Ausbildung der Prozessbox (1), wobei der Deckel (8) so ausgebildet ist, dass Beschichtungen (4a, 4b) der Substrate (3a, 3b) durch an der Oberseite (27) des Deckels (8) zugeführte Strahlung wärmebehandelbar sind,
b) Transportieren der Prozessbox (1) in eine Wärmebehandlungskammer (29) mit Heizstrahlern (30),
c) Zuführen von Strahlung an der Unterseite (9) des Bodens (5) und/oder Zuführen von Strahlung an der Oberseite (27) des Deckels (8) zum Wärmebehandeln der Beschichtungen (4a, 4b) der Substrate (3a, 3b).

7. Verfahren nach Anspruch 6, bei welchem das Zwischenelement (7) bei einer ersten Alternative auf eine vom Rahmen (6) geformte Stufe (12) oder bei einer zweiten Alternative auf einen auf dem Boden (5) abgestützten, ersten Abstandshalter (22) und/oder auf einen auf dem ersten Substrat (3a) abgestützten, zweiten Abstandshalter (24) lose aufgesetzt wird.

8. Anordnung (28) zum Prozessieren einseitig beschichteter Substrate (3a, 3b) in einer Prozessbox (1), umfassend:
einen transportierbaren Prozessträger (2), mit einem Boden (5), welcher so ausgebildet ist, dass ein erstes Substrat (3a) mit seiner unbeschichteten Substratseite vollflächig unterstützt auflegbar ist und Beschichtungen (4a, 4b) der Substrate (3a, 3b) durch an der Unterseite (9) des Bodens (5) zugeführte Strahlung wärmebehandelbar sind, einem Rahmen (6) welcher so ausgebildet ist, dass er den Boden (5) mit einem Deckel (8) verbindet und der Deckel (8) auf den Rahmen lose aufsetzbar ist, einem Zwischenelement (7), welches so ausgebildet ist, dass ein zweites Substrat (3b) mit seiner unbeschichteten Substratseite vollflächig unterstützt auflegbar ist, wobei das Zwischenelement auf eine Stufe (12) des Rahmens (6) lose aufgesetzt ist, einen in einer Prozesskammer (29) stationär angeordneten Deckel (8) zum losen Aufsetzen auf den Rahmen (6) des Prozessträgers (2) zur Formung der Prozessbox (1), wobei der Deckel (8) so ausgebildet ist, dass Beschichtungen (4a, 4b) der Substrate (3a, 3b) durch an der Oberseite (27) des Deckels (8) zugeführte Strahlung wärmebehandelbar sind,
ein Bewegungsmechanismus (21) zum Bewegen von Deckel (8) und/oder Prozessträger (2), wobei der Bewegungsmechanismus so ausgebildet ist, dass der Deckel (8) auf den Rahmen (6) aufsetzbar ist.

9. Verfahren zum Prozessieren einseitig beschichteter Substrate (3a, 3b) in einer Anordnung (28) nach Anspruch 8, mit den folgenden Schritten:
a) Montieren und Beladen eines transportierbaren Prozessträgers (2), durch
- bei einer ersten Alternative: Bereitstellen eines Bodens (5), durch den ein erstes Substrat (3a) mit seiner unbeschichteten Substratseite vollflächig unterstützt werden kann und welcher so ausgebildet ist, dass Beschichtungen (4a, 4b) der Substrate (3a, 3b) durch an der Unterseite (9) des Bodens (5) zugeführte Strahlung wärmebehandelbar sind, und loses Aufsetzen eines Rahmens (6) auf den Boden (5) zur Verbindung des Bodens (5) mit einem Deckel (8) oder bei einer zweiten Alternative: Bereitstellen eines Bodens (5), durch den ein erstes Substrat (3a) mit seiner unbeschichteten Substratseite vollflächig unterstützt werden kann und welcher so ausgebildet ist, dass Beschichtungen (4a, 4b) der Substrate (3a, 3b) durch an der Unterseite (9) des Bodens (5) zugeführte Strahlung wärmebehandelbar sind, wobei der Boden mit einem Rahmen (6) fest verbunden ist, welcher zur Verbindung des Bodens (5) mit einem Deckel (8) dient,
- gegebenenfalls Auflegen des ersten Substrats (3a) auf den Boden (5),
- loses Aufsetzen eines Zwischenelements (7), durch das ein zweites Substrat (3b) mit seiner unbeschichteten Substratseite vollflächig unterstützt werden kann, bei einer ersten Alternative auf eine vom Rahmen (6) geformte Stufe (12) oder bei einer zweiten Alternative auf einen auf dem Boden (5) abgestützten, ersten Abstandshalter (22) und/oder auf einen auf dem ersten Substrat (3a) abgestützten, zweiten Abstandshalter (24),
- gegebenenfalls Auflegen des zweiten Substrats (3b) auf das Zwischenelement (7),
b) Transportieren des Prozessträgers (2) in eine Wärmebehandlungskammer (29) mit Heizstrahlern (30),
c) loses Aufsetzen eines in der Wärmebehandlungskammer (30) stationär angeordneten Deckels (8) auf den Rahmen (6) zur Ausbildung der Prozessbox (1), wobei der Deckel (8) so ausgebildet ist, dass Beschichtungen (4a, 4b) der Substrate (3a, 3b) durch an der Oberseite (27) des Deckels (8) zugeführte Strahlung wärmebehandelbar sind,
d) Zuführen von Strahlung an der Unterseite (9) des Bodens (5) und/oder Zuführen von Strahlung an der Oberseite (27) des Deckels (8) zum Wärmebehandeln der Beschichtungen (4a, 4b) der Substrate (3a, 3b).

10. Anordnung (28) zum Prozessieren einseitig beschichteter Substrate (3a, 3b) in einer Prozessbox (1), umfassend:
einen transportierbaren Prozessträger (2), mit einem Boden (5), welcher so ausgebildet ist, dass ein erstes Substrat (3a) mit seiner unbeschichteten Substratseite vollflächig unterstützt auflegbar ist und Beschichtungen (4a, 4b) der Substrate (3a, 3b) durch an der Unterseite (9) des Bodens (5) zugeführte Strahlung wärmebehandelbar sind, einem Zwischenelement (7), welches so ausgebildet ist, dass ein zweites Substrat (3b) mit seiner unbeschichteten Substratseite vollflächig unterstützt auflegbar ist, wobei das Zwischenelement (7) auf einen auf dem Boden (5) abgestützten, ersten Abstandshalter (22) und/oder auf einen auf dem ersten Substrat (3a) abgestützten, zweiten Abstandshalter (24) lose aufgesetzt ist, einen in einer Prozesskammer (29) stationär angeordneten Deckel (8) mit einem daran befestigten Rahmen (6) zum Verbinden von Boden (5) und Deckel (8) zur Formung der Prozessbox (1), wobei der Deckel (8) so ausgebildet ist, dass Beschichtungen (4a, 4b) der Substrate (3a, 3b) durch an der Oberseite (27) des Deckels (8) zugeführte Strahlungsenergie wärmebehandelbar sind,
ein Bewegungsmechanismus (21) zum Bewegen von Deckel (8) mit Rahmen (6) und/oder Prozessträger (2), welcher so ausgebildet ist, dass der Rahmen (6) auf den Boden (5) lose aufsetzbar ist.

11. Verfahren zum Prozessieren einseitig beschichteter Substrate (3a, 3b) in einer Anordnung (28) nach Anspruch 10, mit den folgenden Schritten:
a) Montieren und Beladen eines transportierbaren Prozessträgers (2), durch
- Bereitstellen eines Bodens (5), durch den ein erstes Substrat (3a) mit seiner unbeschichteten Substratseite vollflächig unterstützt werden kann und welcher so ausgebildet ist, dass Beschichtungen (4a, 4b) der Substrate (3a, 3b) durch an der Unterseite (9) des Bodens (5) zugeführte Strahlung wärmebehandelbar sind,
- gegebenenfalls Auflegen des ersten Substrats (3a) auf den Boden (5),
- Aufsetzen eines Zwischenelements (7), durch das ein zweites Substrat (3b) mit seiner unbeschichteten Substratseite vollflächig unterstützt werden kann, auf einen auf dem Boden (5) abgestützten ersten Abstandshalter (22) und/oder auf einen auf dem ersten Substrat (3a) abgestützten, zweiten Abstandshalter (24),
- gegebenenfalls Auflegen des zweiten Substrats (3b) auf das Zwischenelement (7),
b) Transportieren des beladenen Prozessträgers (2) in eine Wärmebehandlungskammer (29) mit Heizstrahlern (30),
c) loses Aufsetzen eines in der Wärmebehandlungskammer (29) stationär angeordneten, mit einem Deckel (8) fest verbundenen Rahmens (6) auf den Boden (5) zur Ausbildung der Prozessbox (1), wobei der Deckel (8) so ausgebildet ist, dass Beschichtungen (4a, 4b) der Substrate (3a, 3b) durch an der Oberseite (27) des Deckels (8) zugeführte Strahlung wärmebehandelbar sind,
d) Zuführen von Strahlung an der Unterseite (9) des Bodens (5) und/oder Zuführen von Strahlung an der Oberseite (27) des Deckels (8) zum Wärmebehandeln der Beschichtungen (4a, 4b) der Substrate (3a, 3b).

## Claims

1. Transportable process box (1) for processing substrates coated on one side (3a, 3b), comprising:
a base (5), which is implemented such that a first substrate (3a) is placeable with its uncoated substrate side with full-area support and coatings (4a, 4b) of the substrates (3a, 3b) are thermally treatable by radiation supplied on the underside (9) of the base (5),
a frame (6) for connecting the base (5) to a cover (8),
an intermediate element (7), which is implemented such that a second substrate (3b) is placeable with its uncoated substrate side with full-area support,
a cover (8), which is mounted on the frame (6) and is implemented such that coatings (4a, 4b) of the substrates (3a, 3b) are thermally treatable by radiation supplied on the top side (27) of the cover (8), wherein a processing space (17) for processing the substrates (3a, 3b) is formed by the base (5), cover (8), and frame (6).

2. Process box (1) according to claim 1, wherein the intermediate element (7) is loosely mounted on a step (12) formed by the frame (6), wherein the intermediate element (7) divides the processing space (17) into a first processing subspace (17a) for processing the first substrate (3a) and a second processing subspace (17b) for processing the second substrate (3b).

3. Process box (1) according to claim 1, wherein the intermediate element (7) is loosely mounted on a first spacer (22) supported on the base (5) and/or on a second spacer (24) supported on the first substrate (3a), wherein the intermediate element (7) is implemented such that it, together with the first spacer (22) or second spacer (24), divides the processing space (17) into a first processing subspace (17a) for processing the first substrate (3a) and a second processing subspace (17b) for processing the second substrate (3b).

4. Process box (1) according to claim 3, wherein the second spacer (24) is supported in a coating-free edge zone (14) of the first substrate (3a).

5. Process box (1) according to one of claims 1 through 4, wherein the frame (6) is loosely mounted on the base (5).

6. Method for processing substrates coated on one side (3a, 3b) in a transportable process box (1) according to one of claims 1 through 5, comprising the following steps:
a) installing and loading the process box (1) by
- preparing a base (5), by means of which a first substrate (3a) can be supported with its uncoated substrate side over its full area and which is implemented such that coatings (4a, 4b) of substrates (3a, 3b) are thermally treatable by radiation supplied on the underside (9) of the base (5),
- loose mounting of a frame (6) on the base (5) for connecting the base (5) to a cover (8),
- optionally, placing the first substrate (3a) on the base (5),
- arranging an intermediate element (7), by means of which a second substrate (3b) can be supported with its uncoated substrate side over its full area,
- optionally, placing the second substrate (3a) on the intermediate element (7),
- mounting the cover (8) on the frame (6) to form the process box (1), wherein the cover (8) is implemented such that coatings (4a, 4b) of the substrates (3a, 3b) are thermally treatable by radiation supplied on the top side (27) of the cover (8),
b) transporting the process box (1) into a thermal treatment chamber (29) with radiant heaters (30),
c) supplying radiation on the underside (9) of the base (5) and/or supplying radiation on the top side (27) of the cover (8) for the thermal treatment of the coatings (4a, 4b) of the substrates (3a, 3b).

7. Method according to claim 6, wherein the intermediate element (7), in a first alternative, is loosely mounted on a step (12) formed by the frame (6) or, in a second alternative, is loosely mounted on a first spacer (22) supported on the base (5) and/or on a second spacer (24) supported on the first substrate (3a).

8. Arrangement (28) for processing substrates coated on one side (3a, 3b) in a process box (1), comprising:
a transportable process carrier (2), with a base (5), which is implemented such that a first substrate (3a) is placeable with its uncoated substrate side with full-area support and coatings (4a, 4b) of the substrates (3a, 3b) are thermally treatable by radiation supplied on the underside (9) of the base (5), a frame (6), which is implemented such that it connects the base (5) to a cover (8) and the cover (8) is loosely mountable on the frame, an intermediate element (7), which is implemented such that a second substrate (3b) is placeable with its uncoated substrate side with full-area support, wherein the intermediate element is loosely mounted on a step (12) of the frame (6), a cover (8) arranged stationarily in a process chamber (29) for loose mounting on the frame (6) of the process carrier (2) to form the process box (1), wherein the cover (8) is implemented such that coatings (4a, 4b) of the substrates (3a, 3b) are thermally treatable by radiation supplied on the top side (27) of the cover (8),
a movement mechanism (21) for moving cover (8) and/or process carrier (2), wherein the movement mechanism is implemented such that the cover (8) is mountable on the frame (6).

9. Method for processing substrates coated on one side (3a, 3b) in an arrangement (28) according to claim 8, with the following steps:
a) installing and loading a transportable process carrier (2), by
- In a first alternative: preparing a base (5), by means of which a first substrate (3a) can be supported with its uncoated substrate side over its full area and which is implemented such that coatings (4a, 4b) of the substrates (3a, 3b) are thermally treatable by radiation supplied on the underside (9) of the base (5), and loose mounting of a frame (6) on the base (5) for connecting the base (5) to a cover (8) or, in a second alternative: preparing a base (5), by means of which a first substrate (3a) can be supported with its uncoated substrate side over its full area and which is implemented such that coatings (4a, 4b) of the substrates (3a, 3b) are thermally treatable by radiation supplied on the underside (9) of the base (5), wherein the base is fixedly connected to a frame (6), which serves for connecting the base (5) to a cover (8),
- optionally, placing the first substrate (3a) on the base (5),
- loose mounting of an intermediate element (7), by means of which a second substrate (3b) can be supported over its full area, in a first alternative, on a step (12) formed by the frame (6), or, in a second alternative, on a first spacer (22) supported on the base (5) and/or on a second spacer (24) supported on the first substrate (3a),
- optionally, placing the second substrate (3b) on the intermediate element (7),
b) transporting the process carrier (2) into a thermal treatment chamber (29) with radiant heaters (30),
c) loose mounting of a cover (8) arranged stationarily in the thermal treatment chamber (30) on the frame (6) to form the process box (1), wherein the cover (8) is implemented such that coatings (4a, 4b) of the substrates (3a, 3b) are thermally treatable by radiation supplied on the top side (27) of the cover (8),
d) supplying radiation on the underside (9) of the base (5) and/or supplying radiation on the top side (27) of the cover (8) for the thermal treatment of the coatings (4a, 4b) of the substrates (3a, 3b).

10. Arrangement (28) for processing substrates coated on one side (3a, 3b) in a process box (1), comprising:
a transportable process carrier (2), with a base (5), which is implemented such that a first substrate (3a) is placeable with its uncoated substrate side with full-area support and coatings (4a, 4b) of the substrates (3a, 3b) are thermally treatable by radiation supplied on the underside (9) of the base (5), an intermediate element (7), which is implemented such that a second substrate (3b) is placeable with its uncoated substrate side with full-area support, wherein the intermediate element (7) is loosely mounted on a first spacer (22) supported on the base (5) and/or is loosely mounted on a second spacer (24) supported on the first substrate (3a), a cover (8) arranged stationarily in a process chamber (29) with a frame (6) fastened thereon for connecting the base (5) and cover (8) to form the process box (1), wherein the cover (8) is implemented such that coatings (4a, 4b) of the substrates (3a, 3b) are thermally treatable by radiation energy supplied on the top side (27) of the cover (8),
a movement mechanism (21) for moving the cover (8) with frame (6) and/or process carrier (2), which is implemented such that the frame (6) is loosely mountable on the base (5).

11. Method for processing substrates coated on one side (3a, 3b) in an arrangement (28) according to claim 10, comprising the following steps:
a) installing and loading a transportable process carrier (2), by
- preparing a base (5), by means of which a first substrate (3a) can be supported with its uncoated substrate side over its full area and which is implemented such that coatings (4a, 4b) of the substrates (3a, 3b) are thermally treatable by radiation supplied on the underside (9) of the base (5),
- optionally, placing the first substrate (3a) on the base (5),
- mounting an intermediate element (7), by means of which a second substrate (3b) can be supported with its uncoated substrate side over its full area, on a first spacer (22) supported on the base (5) and/or on a second spacer (24) supported on the first substrate (3a),
- optionally, placing the second substrate (3b) on the intermediate element (7),
b) transporting the loaded process carrier (2) into a thermal treatment chamber (29) with radiant heaters (30),
c) loose mounting of a frame (6) fixedly connected to a cover (8) and stationarily arranged in the thermal treatment chamber (29), wherein the cover is implemented such that coatings (4a, 4b) of the substrates (3a, 3b) are thermally treatable by radiation supplied on the top side (27) of the cover (8),
d) supplying radiation on the underside (9) of the base (5) and/or supplying radiation on the top side (27) of the cover (8) for the thermal treatment of the coatings (4a, 4b) of the substrates (3a, 3b).

## Revendications

1. Boîte de traitement transportable (1) pour le traitement de substrats revêtus sur une face (3a, 3b), comprenant:
une base (5), qui est réalisée de telle sorte qu'un premier substrat (3a) peut être placé avec sa face non revêtue avec un support sur toute la surface et que les revêtements (4a, 4b) des substrats (3a, 3b) peuvent être traités thermiquement par rayonnement fourni sur la face inférieure (9) de la base (5),
un cadre (6) pour relier la base (5) à un couvercle (8),
un élément intermédiaire (7), qui est mis en oeuvre de telle sorte qu'un deuxième substrat (3b) puisse être placé avec sa face de substrat non revêtue avec un support sur toute la surface,
un couvercle (8), qui est monté sur le cadre (6) et est réalisé de telle sorte que les revêtements (4a, 4b) des substrats (3a, 3b) peuvent être traités thermiquement par un rayonnement amené sur la face supérieure (27) du couvercle (8), un espace de traitement (17) pour le traitement des substrats (3a, 3b) étant formé par la base (5), le couvercle (8) et le cadre (6).

2. Boîte de traitement (1) selon la revendication 1, dans laquelle l'élément intermédiaire (7) est monté de manière lâche sur un gradin (12) formé par le cadre (6), dans laquelle l'élément intermédiaire (7) divise l'espace de traitement (17) en un premier sous-espace de traitement (17a) pour le traitement du premier substrat (3a) et un second sous-espace de traitement (17b) pour le traitement du second substrat (3b).

3. Boîte de traitement (1) selon la revendication 1, dans lequel l'élément intermédiaire (7) est monté de manière lâche sur un premier espaceur (22) supportée sur la base (5) et/ou sur un deuxième espaceur (24) supportée sur le premier substrat (3a), dans lequel l'élément intermédiaire (7) est réalisé de telle sorte qu'il, avec le premier espaceur (22) ou le deuxième espaceur (24), divise l'espace de traitement (17) en un premier sous-espace de traitement (17a) pour le traitement du premier substrat (3a) et un deuxième sous-espace de traitement (17b) pour le traitement du deuxième substrat (3b).

4. Boîte de traitement (1) selon la revendication 3, dans laquelle le deuxième espaceur (24) est supporté dans une zone de bord (14) sans revêtement du premier substrat (3a).

5. Boîte de traitement (1) selon l'une des revendications 1 à 4, dans laquelle le cadre (6) est monté librement sur la base (5).

6. Procédé de traitement de substrats revêtus sur une face (3a, 3b) dans une boîte de traitement transportable (1) selon l'une des revendications 1 à 5, comprenant les étapes suivantes:
a) installation et chargement de la boîte de traitement (1) par
- la préparation d'une base (5), au moyen duquel un premier substrat (3a) peut être supporté sur toute sa surface avec sa face non revêtue et qui est réalisé de telle sorte que les revêtements (4a, 4b) des substrats (3a, 3b) puissent être traités thermiquement par le rayonnement fourni sur la face inférieure (9) de la base (5),
- montage libre d'un cadre (6) sur la base (5) pour relier la base (5) à un couvercle (8),
- éventuellement, en plaçant le premier substrat (3a) sur la base (5),
- disposer un élément intermédiaire (7), au moyen duquel un deuxième substrat (3b) peut être supporté avec sa face de substrat non revêtue sur toute sa surface,
- éventuellement, en plaçant le second substrat (3a) sur l'élément intermédiaire (7),
- montage du couvercle (8) sur le cadre (6) pour former la boîte de traitement (1), le couvercle (8) étant réalisé de telle sorte que les revêtements (4a, 4b) des substrats (3a, 3b) peuvent être traités thermiquement par le rayonnement fourni sur la face supérieure (27) du couvercle (8),
b) le transport de la boîte de traitement (1) dans une chambre de traitement thermique (29) avec des chauffages rayonnants (30),
c) l'irradiation de la face inférieure (9) de la base (5) et/ou l'irradiation de la face supérieure (27) du couvercle (8) pour le traitement thermique des revêtements (4a, 4b) des substrats (3a, 3b).

7. Procédé selon la revendication 6, dans lequel l'élément intermédiaire (7), dans une première variante, est monté de manière lâche sur un gradin (12) formé par le cadre (6) ou, dans une seconde variante, est monté de manière lâche sur un premier espaceur (22) supportée sur la base (5) et/ou sur une deuxième espaceur (24) supportée sur le premier substrat (3a).

8. Dispositif (28) pour le traitement de substrats revêtus sur une face (3a, 3b) dans une boîte de traitement (1), comprenant:
un support de processus (2) transportable, avec une base (5), qui est réalisé de telle sorte qu'un premier substrat (3a) peut être placé avec sa face de substrat non revêtue sur toute la surface et que les revêtements (4a, 4b) des substrats (3a, 3b) peuvent être traités thermiquement par un rayonnement amené sur la face inférieure (9) de la base (5), un cadre (6), qui est réalisé de telle sorte qu'il relie la base (5) à un couvercle (8) et que le couvercle (8) peut être monté librement sur le cadre, un élément intermédiaire (7), qui est réalisé de telle sorte qu'un deuxième substrat (3b) peut être placé avec sa face de substrat non revêtue avec un support sur toute la surface, l'élément intermédiaire étant monté de manière lâche sur une marche (12) du cadre (6), un couvercle (8) disposé de manière fixe dans une chambre de traitement (29) pour le montage libre sur le cadre (6) du support de traitement (2) pour former la boîte de traitement (1), le couvercle (8) étant réalisé de telle sorte que les revêtements (4a, 4b) des substrats (3a, 3b) peuvent être traités thermiquement par le rayonnement fourni sur la face supérieure (27) du couvercle (8),
un mécanisme de déplacement (21) pour déplacer le couvercle (8) et/ou le support de processus (2), dans lequel le mécanisme de déplacement est mis en oeuvre de telle sorte que le couvercle (8) puisse être monté sur le cadre (6).

9. Procédé de traitement de substrats revêtus sur une face (3a, 3b) dans un agencement (28) selon la revendication 8, avec les étapes suivantes:
a) Installation et chargement d'un support de traitement transportable (2), par
- dans une première variante : préparation d'une base (5), au moyen de laquelle un premier substrat (3a) peut être supporté sur toute sa surface avec sa face non revêtue et qui est réalisée de telle sorte que les revêtements (4a, 4b) des substrats (3a, 3b) puissent être traités thermiquement par rayonnement fourni sur la face inférieure (9) de la base (5), et montage libre d'un cadre (6) sur la base (5) pour relier la base (5) à un couvercle (8) ou, dans une deuxième variante : préparation d'une base (5), au moyen duquel un premier substrat (3a) peut être supporté sur toute sa surface avec sa face de substrat non revêtue et qui est réalisé de telle sorte que les revêtements (4a, 4b) des substrats (3a, 3b) peuvent être traités thermiquement par un rayonnement amené sur la face inférieure (9) de la base (5), le base étant relié de manière fixe à un cadre (6), qui sert à relier las base (5) à un couvercle (8),
- éventuellement, en plaçant le premier substrat (3a) sur la base (5),
- montage libre d'un élément intermédiaire (7), au moyen duquel un deuxième substrat (3b) peut être supporté sur toute sa surface, dans une première variante, sur une marche (12) formée par le cadre (6), ou, dans une deuxième variante, sur un premier espaceur (22) supportée sur la base (5) et/ou sur une deuxième espaceur (24) supportée sur le premier substrat (3a),
- éventuellement, en plaçant le second substrat (3b) sur l'élément intermédiaire (7),
b) le transport du support de processus (2) dans une chambre de traitement thermique (29) avec des radiateurs (30),
c) montage libre d'un couvercle (8) disposé de manière fixe dans la chambre de traitement thermique (30) sur le cadre (6) pour former la boîte de traitement (1), le couvercle (8) étant réalisé de telle sorte que les revêtements (4a, 4b) des substrats (3a, 3b) peuvent être traités thermiquement par le rayonnement fourni sur la face supérieure (27) du couvercle (8),
d) l'irradiation de la face inférieure (9) de la base (5) et/ou l'irradiation de la face supérieure (27) du couvercle (8) pour le traitement thermique des revêtements (4a, 4b) des substrats (3a, 3b).

10. Dispositif (28) pour le traitement des substrats revêtus sur une face (3a, 3b) dans une boîte de traitement (1), comprenant:
un support de processus transportable (2) avec une base (5), qui est conçu de telle sorte qu'un premier substrat (3a) peut être posé avec sa face de substrat non revêtue sur toute la surface et que les revêtements (4a, 4b) des substrats (3a, 3b) peuvent être traités thermiquement par un rayonnement amené sur la face inférieure (9) de la base (5), un élément intermédiaire (7), qui est conçu de telle sorte qu'un deuxième substrat (3b) peut être posé avec sa face de substrat non revêtue sur toute la surface, dans lequel l'élément intermédiaire (7) est monté de manière lâche sur un premier espaceur (22) supportée sur la base (5) et/ou est monté de manière lâche sur une deuxième espaceur (24) supportée sur le premier substrat (3a), un couvercle (8) disposé de manière fixe dans une chambre de traitement (29) avec un cadre (6) fixé sur celui-ci pour relier la base (5) et le couvercle (8) afin de former la boîte de traitement (1), le couvercle (8) étant réalisé de telle sorte que les revêtements (4a, 4b) des substrats (3a, 3b) peuvent être traités thermiquement par l'énergie de rayonnement fournie sur la face supérieure (27) du couvercle (8),
un mécanisme de déplacement (21) pour déplacer le couvercle (8) avec le cadre (6) et/ou le support de processus (2), qui est mis en oeuvre de telle sorte que le cadre (6) puisse être monté librement sur la base (5).

11. Procédé de traitement de substrats revêtus sur une face (3a, 3b) dans un agencement (28) selon la revendication 10, comprenant les étapes suivantes:
a) installation et chargement d'un support de traitement transportable (2), en
- la préparation d'une base (5), au moyen duquel un premier substrat (3a) peut être supporté avec sa face non revêtue sur toute sa surface et qui est réalisé de telle sorte que les revêtements (4a, 4b) des substrats (3a, 3b) puissent être traités thermiquement par le rayonnement fourni sur la face inférieure (9) de la base (5),
- éventuellement, en plaçant le premier substrat (3a) sur la base (5),
- montage d'un élément intermédiaire (7), au moyen duquel un deuxième substrat (3b) peut être supporté avec sa face non revêtue sur toute sa surface, sur un premier espaceur (22) supportée sur la base (5) et/ou sur une deuxième espaceur (24) supportée sur le premier substrat (3a),
- éventuellement, en plaçant le second substrat (3b) sur l'élément intermédiaire (7),
b) le transport du support de processus chargé (2) dans une chambre de traitement thermique (29) avec des radiateurs (30),
c) montage libre d'un cadre (6) relié de manière fixe à un couvercle (8) et disposé de manière stationnaire dans la chambre de traitement thermique (29), le couvercle étant réalisé de telle sorte que les revêtements (4a, 4b) des substrats (3a, 3b) peuvent être traités thermiquement par rayonnement fourni sur la face supérieure (27) du couvercle (8),
d) l'irradiation de la face inférieure (9) de la base (5) et/ou l'irradiation de la face supérieure (27) du couvercle (8) pour le traitement thermique des revêtements (4a, 4b) des substrats (3a, 3b).
